(19) Europäisches Patentamt
European Patent Office
Office européen des brevets

(11) **EP 3 022 782 B1**

(12) **EUROPÄISCHE PATENTSCHRIFT**

(45) Veröffentlichungstag und Bekanntmachung des Hinweises auf die Patenterteilung:
**19.02.2020 Patentblatt 2020/08**

(21) Anmeldenummer: **14738860.7**

(22) Anmeldetag: **15.07.2014**

(51) Int Cl.:
*H01L 51/52* (2006.01)          *H01L 51/50* (2006.01)

(86) Internationale Anmeldenummer:
**PCT/EP2014/065152**

(87) Internationale Veröffentlichungsnummer:
**WO 2015/007733 (22.01.2015 Gazette 2015/03)**

(54) **VERFAHREN ZUM BETRIEB EINES ORGANISCHEN LICHT EMITTIERENDEN BAUELEMENTS**

METHOD FOR OPERATING AN ORGANIC LIGHT-EMITTING COMPONENT

PROCÉDÉ DE FONCTIONNEMENT D'UN COMPOSANT PHOTOÉMETTEUR ORGANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.07.2013 DE 102013107529**

(43) Veröffentlichungstag der Anmeldung:
**25.05.2016 Patentblatt 2016/21**

(73) Patentinhaber: **OSRAM OLED GmbH**
**93049 Regensburg (DE)**

(72) Erfinder:
• **KRUMMACHER, Benjamin, Claus**
**93051 Regensburg (DE)**
• **LANG, Erwin**
**93051 Regensburg (DE)**
• **VEHOFF, Thorsten**
**93047 Regensburg (DE)**
• **NIEDERMEIER, Ulrich**
**94339 Leiblfing (DE)**

(74) Vertreter: **Epping - Hermann - Fischer**
**Patentanwaltsgesellschaft mbH**
**Schloßschmidstraße 5**
**80639 München (DE)**

(56) Entgegenhaltungen:
**US-A1- 2009 189 532     US-A1- 2010 084 635**

**Beschreibung**

Es wird ein Verfahren zum Betrieb eines organischen Licht emittierenden Bauelements beschrieben.

Diese Patentanmeldung beansprucht die Priorität der deutschen Patentanmeldung 10 2013 107 529.0.

Bei dem Verfahren wird ein organisches Licht emittierenden Bauelement betrieben, so dass das Bauelement über eine Leuchtfläche Licht abstrahlt, das über die Leuchtfläche variiert. Insbesondere kann bei dem Verfahren das Licht mit einer Leuchtdichteverteilung, die einen Leuchtdichtegradienten aufweist, von der Leuchtfläche abgestrahlt werden.

Beispielsweise für Beleuchtungszwecke kann es wünschenswert sein, anstelle einer herkömmlichen statischen Lichtquelle, die Licht mit einer räumlich und zeitlich nicht variierenden Leuchtdichteverteilung abstrahlt, eine Lichtquelle zu verwenden, die einen Leuchtdichtegradienten und/oder einen Farbgradienten aufweist. Weiterhin kann es wünschenswert sein, den Gradienten zeitlich und/oder räumlich zu variieren. Zumindest eine Aufgabe von bestimmten Ausführungsformen ist es daher, ein Verfahren zum Betrieb eines organischen Licht emittierenden Bauelements anzugeben, bei dem eine zeitliche und/oder räumliche Variation eines abgestrahlten Lichts eines organischen Licht emittierenden Bauelements erzeugt wird.

Die Druckschrift US 2009/189532 A1 offenbart ein organisches Licht emittierendes Bauelement das Licht abstrahlt, das über eine Leuchtfläche variiert und einen Leuchtdichtegradienten aufweist.

Diese Aufgabe wird durch Verfahren gemäß den unabhängigen Patentansprüchen gelöst. Vorteilhafte Ausführungsformen und Weiterbildungen der Verfahren sind in den abhängigen Ansprüchen gekennzeichnet und gehen weiterhin aus der nachfolgenden Beschreibung und den Zeichnungen hervor.

Gemäß zumindest einer Ausführungsform wird bei einem Verfahren zum Betrieb eines organischen Licht emittierenden Bauelements ein organisches Licht emittierendes Bauelement bereitgestellt und verwendet, das eine erste Elektrode und eine zweite Elektrode aufweist, zwischen denen ein organischer funktioneller Schichtenstapel mit zumindest einer organischen Licht emittierenden Schicht angeordnet ist.

Gemäß einer weiteren Ausführungsform weist das organische Licht emittierende Bauelement weiterhin ein Substrat auf, auf dem die erste Elektrode und die zweite Elektrode angeordnet sind. Mit dem zwischen den Elektroden angeordneten organischen funktionellen Schichtenstapel bilden die Elektroden und das Substrat einen funktionellen Schichtenstapel. Mit dem "organischen funktionellen Schichtenstapel" wird hier und im folgenden die Gesamtheit der organischen Schichten des organischen Licht emittierenden Bauelements bezeichnet, die zwischen den Elektroden angeordnet sind, während der "funktionelle Schichtenstapel" zusätzlich zum organischen funktionellen Schichtenstapel zumindest noch die Elektroden und das Substrat aufweist. Das organische Licht emittierende Bauelement kann insbesondere als organische Licht emittierende Diode (OLED) ausgebildet sein, die als zumindest eine organische Licht emittierende Schicht zumindest eine elektrolumineszierende Schicht aufweist.

Der organische funktionelle Schichtstapel kann Schichten mit organischen Polymeren, organischen Oligomeren, organischen Monomeren, organischen kleinen, nicht-polymeren Molekülen ("small molecules") oder Kombinationen daraus aufweisen. Insbesondere kann es vorteilhaft sein, wenn der organische funktionelle Schichtenstapel eine oder mehrere organische funktionelle Schichten aufweist, die als Lochtransportschichten ausgeführt sind, um eine effektive Löcherinjektion in die zumindest eine Licht emittierende Schicht zu ermöglichen. Als Materialien für eine Lochtransportschicht können sich beispielsweise tertiäre Amine, Carbazolderivate, leitendes Polyanilin oder Polyethylendioxythiophen als vorteilhaft erweisen. Als Materialien für die zumindest eine organische Licht emittierende Schicht eignen sich Materialien, die eine Strahlungsemission aufgrund von Fluoreszenz oder Phosphoreszenz aufweisen, beispielsweise Polyfluoren, Polythiophen oder Polyphenylen oder Derivate, Verbindungen, Mischungen oder Copolymere davon. Weiterhin kann der organische funktionelle Schichtenstapel eine oder mehrere funktionelle Schichten aufweisen, die als Elektronentransportschichten ausgebildet sind. Darüber hinaus kann der Schichtenstapel auch Elektronen- und/oder Löcherblockierschichten aufweisen. Der organische funktionelle Schichtenstapel kann auch eine Mehrzahl von organischen Licht emittierenden Schichten aufweisen, die zwischen den Elektroden angeordnet sind und die bevorzugt unterschiedlich farbiges Licht abstrahlen.

Im Hinblick auf den prinzipiellen Aufbau eines organischen Licht emittierenden Bauelements, dabei beispielsweise im Hinblick auf den Aufbau, die Schichtzusammensetzung und die Materialien des organischen funktionellen Schichtenstapels, wird auf die Druckschrift WO 2010/066245 A1 verwiesen.

Die Elektroden und der organische funktionelle Schichtenstapel sind jeweils großflächig ausgebildet. Dadurch weist das organische Licht emittierende Bauelement eine zusammenhängende Leuchtfläche auf, die nicht in funktionale Teilbereiche strukturiert ist. Insbesondere handelt es sich bei der Leuchtfläche nicht um eine in funktionale Bereiche segmentierte Leuchtfläche oder um eine Leuchtfläche, die durch eine Vielzahl von Bildpunkten, also so genannten Pixeln, gebildet wird. Dadurch kann eine großflächige Abstrahlung des in der organischen Licht emittierenden Schicht erzeugten Lichts ermöglicht werden. "Großflächig" kann dabei bedeuten, dass das organische Licht emittierende Bauelement und insbesondere die organische Licht emittierende Schicht eine Fläche, besonders bevorzugt eine zusammenhängende Fläche, von größer oder gleich einigen Quadratmillimetern, bevorzugt größer oder gleich einem Quadratzentimeter und besonders bevorzugt größer oder gleich einem Quadratdezimeter aufweist.

Besonders bevorzugt kann das organische Licht emittierende Bauelement nur eine einzige zusammenhängende Leuchtfläche aufweisen, die durch die großflächige und zusammenhängende Ausbildung der Elektroden und des organischen funktionellen Schichtenstapels bewirkt wird.

Gemäß einer weiteren Ausführungsform ist in Kontakt mit der ersten Elektrode an zwei sich gegenüber liegenden Rändern der ersten Elektrode jeweils eine sich in einer Längsrichtung entlang des jeweiligen Rands erstreckende Leiterbahn angeordnet. Mit "Längsrichtung" wird hier und im Folgenden eine Richtung bezeichnet, die entlang des Verlaufs der Ränder, an denen die Leiterbahnen angeordnet sind, verläuft. Mit einer Richtung quer zur Längsrichtung wird hier und im Folgenden eine Richtung bezeichnet, die bevorzugt senkrecht oder zumindest im Wesentlichen senkrecht zur Erstreckungsrichtung der Ränder, an denen die Leiterbahnen angeordnet sind, und parallel zur Haupterstreckungsebene der ersten Elektrode verläuft. Verlaufen die Ränder mit den Leiterbahnen nicht entlang einer Geraden sondern entlang von gebogenen Linien, so sind die Begriffe Längsrichtung und Querrichtung entsprechend dem gebogenen Verlauf zu verstehen. Weiterhin weisen die Leiterbahnen jeweils eine Breite auf, die geringer als ihre Länge entlang des jeweiligen Randes ist. Somit weist jede der Leiterbahnen zwei Längsseiten auf, die entlang des Randverlaufs der ersten Elektrode verlaufen, sowie die Längsseiten verbindende Schmal- oder Querseiten. Besonders bevorzugt kann sich jede der zwei Leiterbahnen entlang des gesamten jeweiligen Randes in Längsrichtung über einen Randbereich der ersten Elektrode erstrecken. Weiterhin kann bevorzugt jede der zwei Leiterbahnen in Längsrichtung eine größere Ausdehnung aufweisen als in einer Richtung quer dazu.

Dadurch, dass die zwei Leiterbahnen an zwei sich gegenüber liegenden Rändern der ersten Elektrode angeordnet sind, befindet sich die Leuchtfläche des organischen Licht emittierenden Bauelements entlang der Querrichtung zwischen den Leiterbahnen.

Gemäß einer weiteren Ausführungsform werden die zwei Leiterbahnen auf einer selben Seite der ersten Elektrode mittels eines elektrischen Anschlusselements kontaktiert. Hierzu kann jede Leiterbahn mit einem eigenen elektrischen Anschlusselement kontaktiert werden. Alternativ hierzu ist es auch möglich, dass die zwei Leiterbahnen durch ein gemeinsames Anschlusselement kontaktiert werden. Eine Kontaktierung auf einer selben Seite der ersten Elektrode bedeutet, dass die Kontaktierung jeweils an einer Schmalseite der Leiterbahnen auf derselben Seite der ersten Elektrode erfolgt. Im Betrieb des organischen Licht emittierenden Bauelements wird über das oder die Anschlusselemente in die zwei Leiterbahnen jeweils ein Betriebsstrom bei einer Betriebsspannung eingespeist, der durch den organischen funktionellen Schichtenstapel zur zweiten Elektrode fließt. Die Leiterbahnen stehen bevorzugt in kontinuierlichem Kontakt zur ersten Elektrode, sodass ein in die Leiterbahnen eingespeister Betriebsstrom über deren gesamte Länge in die erste Elektrode eingespeist werden kann. Es kann aber auch möglich sein, dass die Leiterbahnen neben der ersten Elektrode durchgängig angeordnet sind und kammartig die erste Elektrode kontaktieren, also mit durch kleine Unterbrechungen voneinander getrennten Kontaktbereichen. Aufgrund des Flächenwiderstands der Leiterbahnen und des Flächenwiderstands der ersten Elektrode ergibt sich im Betrieb in jeder Leiterbahn ein Spannungsabfall entlang der Längsrichtung. Der Spannungsabfall bewirkt einen Gradienten in der Betriebsstromdichte im organischen funktionellen Schichtenstapel entlang der Längsrichtung, was wiederum einen Leuchtdichtegradienten auf der Leuchtfläche in einer Richtung entlang der Längsrichtung zur Folge hat.

Gemäß einer weiteren Ausführungsform weist das organische Licht emittierende Bauelement eine Kennlinie r auf, die gegeben ist durch r = dV/dj, wobei V eine Betriebsspannung und j eine Betriebsstromdichte bezeichnet und dV/dj die mathematische Ableitung der Betriebsspannung nach der Betriebsstromdichte ist. Die Einheit von r ist $\Omega cm^2$, r beschreibt also den differenziellen Widerstand eines organischen Licht emittierenden Bauelements mit einer bestimmten Fläche. Hierbei taucht ein "Widerstand mal Fläche" auf, was daran liegt, dass eine Vergrößerung der Fläche des organischen Licht emittierenden Bauelements einer Parallelschaltung von Widerständen entspricht, bei der sich nicht die Widerstände, sondern deren Kehrwerte addieren. Zur Auslegung der Kennlinie des organischen Licht emittierenden Bauelements kann beispielsweise ein organischer funktioneller Schichtenstapel zwischen zwei Elektroden herangezogen werden, der mit dem organischen funktionellen Schichtenstapel des organischen Licht emittierenden Bauelements übereinstimmt, jedoch eine möglichst kleine aktive Fläche aufweist. Im thermisch eingeschwungenen Zustand, also nach einem Betrieb eines solchen Referenzbauteils für eine Zeitdauer von typischerweise etwa 10 Minuten beim zu bestimmenden Arbeitspunkt, kann r ermittelt werden.

Gemäß einer weiteren Ausführungsform wird ein Arbeitspunkt r = $r_A$ auf der Kennlinie so gewählt, dass gilt: $0,75 \leq U \leq 1$. Bevorzugt wird r = $r_A$ so gewählt, dass gilt: $0,8 \leq U \leq 0,99$. Besonders bevorzugt wird r = $r_A$ so gewählt, dass gilt: U = 0,8.

U ist hierbei ein Maß für die Homogenität der Leuchtdichte auf der Leuchtfläche, wobei gilt: U = 1 - (1 - H)/(1 + H), H = $\cosh^{-1}$ (L/$\Lambda$) und A = $(r/R)^{0,5}$. Hierbei gilt: L = 0,5 × d, wobei d einen Abstand der Leiterbahnen zueinander in einer Richtung quer zur Längsrichtung bezeichnet. Insbesondere bezeichnet d somit die Breite der Leuchtfläche, wobei diese bei der üblichen Verwendung der Einheiten bei den einzelnen Parametern in Zentimetern gemessen wird. R bezeichnet den Flächenwiderstand der ersten Elektrode.

Die vorab angegebenen Beziehungen für U, H und A ergeben sich aus einem analytischen Modell, bei dem streifenförmige OLEDs betrachtet werden. Λ bezeichnet eine charakteristische Länge, die sich aus dem Flächenwiderstand R der ersten Elektrode und der Kennlinie r, also dem differenziellen Widerstand des organischen Licht emittierenden Bauelements, ergibt. Vergleiche mit Simulationen haben gezeigt, dass das den oben angegebenen Beziehungen zugrunde liegende analytische Modell das Verhalten des organischen Licht emittierenden Bauelements hinreichend genau beschreibt. Von Bedeutung ist insbesondere, welche Homogenität das organische Licht emittierende Bauelement erreicht. Je kleiner der Parameter H ist, je kleiner also auch der Parameter U ist, desto stärker ist der Spannungsabfall über die Leuchtfläche und desto größer ist der Leuchtdichtegradient.

Durch den vorab beschriebenen geeignet gewählten Arbeitspunkt $r = r_A$ kann erreicht werden, dass über die aktive Fläche und damit über die Leuchtfläche des organischen Licht emittierenden Bauelements eine akzeptable Homogenität der Leuchtdichte in Querrichtung erreicht wird, während gleichzeitig ein großer Leuchtdichtegradient in Längsrichtung erreicht wird. Durch die Beziehung zwischen r und der Betriebsstromdichte j gemäß der Kennlinie des organischen Licht emittierenden Bauelements wird dem so bestimmten Arbeitspunkt $r = r_A$ eine Betriebsstromdichte $j_A$ zugeordnet.

Hier und im Folgenden bezeichnet der Parameter "Betriebsstromdichte" die über die Leuchtfläche gemittelte Betriebsstromdichte.

Gemäß einer weiteren Ausführungsform wird das organische Licht emittierende Bauelement mit einem Betriebsstrom zwischen dem oder den Anschlusselementen und der zweiten Elektrode betrieben, der derart gewählt ist, dass die über die Leuchtfläche gemittelte Stromdichte gleich der Betriebsstromdichte $j_A$ ist. Hierbei wird das organische Licht emittierende Bauelement also vereinfacht ausgedrückt mit der Betriebsstromdichte $j_A$ betrieben. Zur Einstellung der Helligkeit der Leuchtfläche bei einem gleichen Leuchtdichtegradienten kann der Betriebsstrom und damit die zugehörige über die Leuchtfläche gemittelte Betriebsstromdichte $j_A$ mittels Pulsweitenmodulation (PWM) moduliert werden, wobei nur die Pulslänge variiert wird und die Pulsamplitude entsprechend der gewünschten Betriebsstromdichte $j_A$ konstant gehalten wird. Zur Einstellung einer maximalen Helligkeit der Leuchtfläche beim Betrieb des organischen Licht emittierenden Bauelements im Arbeitspunkt $r = r_A$ kann die Betriebsstromdichte $j_A$ durch einen Konstantstrom erzeugt werden.

Zur Änderung des Leuchtdichtegradienten kann der Arbeitspunkt $r = r_A$ und damit die entsprechende über die Leuchtfläche gemittelte Betriebsstromdichte $j_A$ variiert werden. Beispielsweise werden ein erster Arbeitspunkt $r = r_{A1}$ mit einer entsprechenden Betriebsstromdichte $j_{A1}$ und ein zweiter Arbeitspunkt $r = r_{A2}$ mit einer entsprechenden Betriebsstromdichte $j_{A2}$ gewählt, wobei gilt: $j_{A2} > j_{A1}$. Für die beiden Arbeitspunkte $r = r_{A1}$ und $r = r_{A2}$ gilt jeweils die weiter oben angegebene Beziehung für die Homogenität U. Im Betrieb des organischen Licht emittierenden Bauelements wird durch eine Variation des zwischen den Anschlusselementen und der zweiten Elektrode anliegenden Betriebsstroms die über die Leuchtfläche gemittelte Betriebsstromdichte j mit $j_{A1} \leq j \leq j_{A2}$ variiert, wodurch der Leuchtdichtegradient auf der Leuchtfläche variiert wird. Durch eine geeignete Wahl des organischen funktionellen Schichtenstapels kann zusätzlich zur Variation des Leuchtdichtegradienten auch eine Variation eines Farbgradienten über die Leuchtfläche erreicht werden.

Besonders bevorzugt kann mittels Pulsweitenmodulation das zeitliche Mittel für jede Betriebsstromdichte j mit $j_{A1} \leq j \leq j_{A2}$ konstant gehalten werden. Dadurch kann erreicht werden, dass die mittlere Leuchtdichte bzw. Helligkeit der Leuchtfläche konstant bleibt, während der Leuchtdichtegradient auf der Leuchtfläche verändert werden kann. Durch das hier beschriebene Pulsweitenmodulationsverfahren kann somit eine gleiche Helligkeit bei unterschiedlichen Leuchtdichtegradienten erzeugt werden.

Gemäß einer weiteren Ausführungsform weist jede Leiterbahn einen Flächenwiderstand von größer oder gleich 10 mΩ/sq und kleiner oder gleich 1000 mΩ/sq auf. Bei einer bevorzugten Bauteillänge in Längsrichtung im Bereich von größer oder gleich 3 cm und kleiner oder gleich 100 cm, bevorzugt größer oder gleich 15 cm und kleiner oder gleich 25 cm, und einer typischen Breite der Leiterbahnen von 2 mm in Querrichtung kann mit einem solchen Flächenwiderstand der Leiterbahnen ein geeigneter Leuchtdichtegradient in Längsrichtung erreicht werden. Besonders bevorzugt beträgt der Flächenwiderstand der Leiterbahnen etwa 70 mΩ/sq.

Gemäß einer weiteren Ausführungsform wird die erste Elektrode anstelle der zwei vorab beschriebenen Leiterbahnen, die auf sich gegenüberliegenden Seiten der ersten Elektrode angeordnet sind, mittels zumindest eines ersten elektrischen Anschlusselements an einem Rand der ersten Elektrode kontaktiert. Unter Berücksichtigung des Flächenwiderstands der ersten Elektrode liegt im Betrieb des organischen Licht emittierenden Bauelements in der ersten Elektrode entlang einer vom zumindest einem ersten Anschlusselement weg führenden Richtung ein Spannungsabfall vor, der einen Leuchtdichtegradienten auf der Leuchtfläche entlang der vom zumindest einen ersten Anschlusselement weg führenden Richtung bewirkt.

Wie bereits weiter oben beschrieben ist, weist das organische Licht emittierende Bauelement eine Kennlinie $r = dV/dj$ auf. Bei der Kontaktierung der ersten Elektrode mit dem zumindest einen ersten Anschlusselements kann ein Arbeitspunkt $r = r_A$ so gewählt werden, dass gilt: $U \leq 0{,}2$, mit $U = 1 - (1-H) / (1+H)$, $H = \cosh^{-1}(L/\Lambda)$ und $\Lambda = (r/R)^{0,5}$. Hierbei gilt $L = d$, wobei d eine Breite der Leuchtfläche quer zum Rand der ersten Elektrode bezeichnet, an den das zumindest eine Anschlusselement angeordnet ist. R ist, wie oben beschrieben, der Flächenwiderstand der ersten Elektrode. Auf diese Weise wird ein ausgeprägter Leuchtdichtegradient in Querrichtung erzeugt.

Durch den Arbeitspunkt $r = r_A$ wird eine Betriebsstromdichte $j_A$ bedingt, durch die der vorab beschriebene Spannungsabfall und damit ein Leuchtdichtegradient auf der Leuchtfläche weg führend vom ersten Anschlusselement erreicht werden kann. Wie weiter oben für die Ausführungsform mit den zwei Leiterbahnen an gegenüber liegenden Seiten der ersten Elektrode beschrieben ist, kann das organische Licht emittierende Bauelement auch in dieser Ausführungsform mit einem konstanten Betriebsstrom entsprechend der Stromdichte $j_A$ betrieben werden. Zur Variation der Helligkeit der Leuchtfläche bei einem gleichen Leuchtdichtegradienten kann der Betriebsstrom und damit die zugehörige über die Leuchtfläche gemittelte Betriebstromsdichte $j_A$ mittels Pulsweitenmodulation (PWM) moduliert werden, wobei nur die Pulslänge variiert wird und die Pulsamplitude entsprechend der gewünschten Betriebsstromdichte $j_A$ konstant gehalten wird. Weiterhin ist es auch möglich, zur Variation des Leuchtdichtegradienten das organische Licht emittierende Bauelement mit einem mittels Pulsweitenmodulation modulierten Betriebsstrom zu betreiben, wobei die Amplitude der Strompulse des PWM-Signals so gewählt sind, dass im zeitlichen Mittel sowie über die Leuchtfläche des organischen Licht emittierenden Bauelements gemittelt die dem Arbeitspunkt $r = r_A$ entsprechende Betriebsstromdichte $j_A$ vorliegt.

Gemäß einer weiteren Ausführungsform wird ein erster Arbeitspunkt $r = r_{A1}$ mit einer entsprechenden Betriebsstromdichte $j_{A1}$ gewählt, für den U $\geq 0{,}8$ gilt. Weiterhin wird ein zweiter Arbeitspunkt $r = r_{A2}$ mit einer entsprechenden Betriebsstromdichte $j_{A2}$ gewählt, für den U $\geq 0{,}8$ gilt. Während der zweite Arbeitspunkt einen Leuchtdichtegradienten in Querrichtung auf der Leuchtfläche hervorruft, bewirkt der erste Arbeitspunkt, dass ein deutlich geringerer oder auch gar kein Leuchtdichtegradient auf der Leuchtfläche wahrgenommen werden kann. Durch eine Variation des zwischen dem zumindest einen Anschlusselement und der zweiten Elektrode anliegenden Betriebsstroms und damit der Betriebsstromdichte j mit $j_{A1} \leq j \leq j_{A2}$ kann eine Variation zwischen einem Leuchtdichtegradienten auf der Leuchtfläche beim zweiten Arbeitspunkt $r_{A2}$ und keinem Leuchtdichtegradienten auf der Leuchtfläche beim ersten Arbeitspunkt $r_{A1}$ erzeugt werden. Insbesondere können die Betriebsstromdichten j mit $j_{A1} \leq j \leq j_{A2}$ mittels Pulsweitenmodulation so moduliert werden, dass eine zeitlich gemittelte Betriebsstromdichte für jede Betriebsstromdichte j mit $j_{A1} \leq j \leq j_{A2}$ konstant gehalten wird, wodurch der Leuchtdichtegradient bei einer gleichbleibenden Helligkeit der Leuchtfläche variiert werden kann.

Das zumindest eine Anschlusselement kann punktuell oder beispielsweise auch über einen Randbereich in Längsrichtung Strom in die erste Elektrode einspeisen. Beispielsweise kann das zumindest eine Anschlusselement auch eine Leiterbahn aufweisen, über die ein Teil oder auch der gesamte Randbereich der ersten Elektrode (eines Randes) kontaktiert wird. Im Unterschied zur Ausführungsform mit den zwei Leiterbahnen auf den gegenüberliegenden Seiten der ersten Elektrode wird bei der vorliegenden Ausführungsform aber kein Spannungsabfall in Längsrichtung in der Leiterbahn beabsichtigt.

Gemäß einer weiteren Ausführungsform weist das organische Licht emittierende Bauelement eine Mehrzahl von elektrischen Anschlusselementen nebeneinander entlang desselben Rands der ersten Elektrode auf. Mit anderen Worten sind zumindest zwei oder mehr Anschlusselemente nebeneinander in einer Längsrichtung der ersten Elektrode an demselben Rand angeordnet. Weiterhin kann es auch möglich sein, dass zumindest ein weiteres Anschlusselement oder eine Mehrzahl von weiteren Anschlusselementen an einem Rand der ersten Elektrode angeordnet sind, der dem Rand mit dem zumindest einem ersten elektrischen Anschlusselement gegenüber liegt. Hierbei können die Anschlusselemente an den zwei gegenüberliegenden Rändern in Längsrichtung jeweils versetzte zueinander angeordnet sein. Darüber hinaus ist es auch möglich, dass an einer Mehrzahl von Rändern der ersten Elektrode jeweils eine Mehrzahl von Anschlusselementen angeordnet ist. Durch eine Anordnung einer Mehrzahl von elektrischen Anschlusselementen an demselben oder an unterschiedlichen Rändern der ersten Elektrode kann eine weitere Beeinflussung der Leuchtdichtegradienten auf der Leuchtfläche erreicht werden. Beispielsweise können die einzelnen elektrischen Anschlusselemente mit unterschiedlichen elektrischen Potenzialen betrieben werden, wobei eine zusätzliche Modulation der Leuchtdichte durch eine zeitliche Variation der elektrischen Potenziale an den unterschiedlichen elektrischen Anschlusselementen erzeugt werden kann.

Gemäß einer weiteren Ausführungsform weist die erste Elektrode bei den vorab beschriebenen jeweiligen Ausführungsformen einen höheren elektrischen Flächenwiderstand als die zweite Elektrode auf. Während es bei üblichen, möglichst homogen abstrahlenden organischen Licht emittierenden Bauelementen ein ständiges Bestreben ist, den Flächenwiderstand der Elektroden möglichst gering zu halten, ist bei den hier beschriebenen Verfahren ein organisches Licht emittierendes Bauelement mit einem gewissen nicht zu niedriger Flächenwiderstand der ersten Elektrode vorteilhaft. Beispielsweise kann es vorteilhaft sein, wenn die erste Elektrode einen um mindestens zehnmal und bevorzugt einen um mindestens hundertmal größeren elektrischen Flächenwiderstand als die zweite Elektrode aufweist. Durch den nicht zu niedrig zu wählenden elektrischen Flächenwiderstand der ersten Elektrode, der den Flächenwiderstand der zweiten Elektrode somit um mindestens einen Faktor 10 und bevorzugt um mindestens einen Faktor 50 und besonders bevorzugt um mindestens einen Faktor 100 übersteigen kann, kann ein gewünschter Spannungsabfall in der ersten Elektrode ausgehend von einem oder mehreren elektrischen Anschlusselementen und/oder Leiterbahnen gemäß der vorab beschriebenen Ausführungsformen mit steigendem Abstand zu diesen hervorgerufen werden. Bevorzugt kann die erste Elektrode einen Flächenwiderstand R mit $0{,}4\ \Omega/sq \leq R \leq 100\ \Omega/sq$ oder mit $1\ \Omega/sq \leq R \leq 20\ \Omega/sq$ aufweisen. Besonders bevorzugt kann der Flächenwiderstand R der ersten Elektrode in einem Bereich von größer oder gleich 2

$\Omega$/sq und kleiner oder gleich 15 $\Omega$/sq sein. Der Flächenwiderstand der ersten Elektrode kann beispielsweise über die Materialwahl und/oder über die Dicke der ersten Elektrode einstellbar sein.

Beispielsweise kann die erste Elektrode ein transparentes leitendes Oxid aufweisen, während die zweite Elektrode ein Metall aufweist. Insbesondere kann die erste Elektrode durch ein transparentes leitendes Oxid gebildet sein oder zumindest eine Schicht aufweisen, die durch ein transparentes leitendes Oxid gebildet wird, während die zweite Elektrode durch ein Metall gebildet wird oder zumindest eine Schicht aufweist die durch ein Metall gebildet wird.

Transparente leitende Oxide ("transparent conductive oxide", TCO) sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, $SnO_2$ oder $In_2O_3$, gehören auch ternäre Metallsauerstoffverbindungen, wie beispielsweise $Zn_2SnO_4$, $CdSnO_3$, $ZnSnO_3$, $MgIn_2O_4$, $GaInO_3$, $Zn_2In_2O_5$ oder $In_4Sn_3O_{12}$ oder Mischungen unterschiedlicher transparenter leitender Oxide, zu der Gruppe der TCOs. Weiterhin entsprechen die TCOs nicht zwingend einer stöchiometrischen Zusammensetzung und können auch p- oder n-dotiert sein.

Das Metall der zweiten Elektrode kann vorzugsweise ausgewählt sein aus Aluminium, Barium, Indium, Silber, Gold, Magnesium, Kupfer, Calcium und Lithium sowie Verbindungen, Kombinationen und Legierungen daraus. Insbesondere kann die zweite Elektrode Ag, Al oder Legierungen mit diesen aufweisen, beispielsweise Ag:Mg, Ag:Ca, Mg:Al. Zusätzlich kann die zweite Elektrode auch eines oder mehrere der oben genannten TCO-Materialien aufweisen. Die zweite Elektrode kann beispielsweise im Hinblick auf ihre Dicke und ihre Zusammensetzung so gewählt sein, dass sie einen geringeren Flächenwiderstand als die erste Elektrode aufweist. Insbesondere die Dicke einer metallischen zweiten Elektrode kann dadurch derart groß sein, dass die zweite Elektrode nicht transparent und weiterhin zumindest teilweise reflektierend ist. Durch eine Kombination von Metall- und TCO-Schichten kann auch eine zumindest teilweise transparente zweite Elektrode mit einem geringen Flächenwiderstand gebildet werden.

Die erste Elektrode kann als Alternative zu einem TCO auch ein transparentes Metall aufweisen oder daraus gebildet sein. Unter einem transparenten Metall wird hier und im Folgenden eine Metallschicht verstanden, die eine derartig geringe Dicke aufweist, dass zumindest ein Teil des vom organischen Licht emittierenden Bauelement im Betrieb erzeugten Lichts durch die Metallschicht gestrahlt werden kann. Die Dicke einer transparenten Metallschicht kann abhängig vom Material und dem durchzustrahlenden Licht beispielsweise einige Nanometer bis zu 30 nm betragen. Beispielsweise ist eine Silberschicht mit einer Dicke von etwa 20 nm transparent und weist einen Flächenwiderstand von etwa 5 $\Omega$/sq auf.

Weiterhin kann es auch möglich sein, dass die erste Elektrode als sogenannte Perkolationselektrode ausgebildet ist und ein mit leitfähigen Partikeln gefülltes transparentes organisches Material aufweist.

Gemäß einer weiteren Ausführungsform weist das organische Licht emittierende Bauelement eine Leuchtfläche mit einer rechteckigen Form oder einer von einem Rechteck abgeleiteten Freiform auf. Die Form der Leuchtfläche kann insbesondere durch die Form der Elektroden und des organischen funktionellen Schichtenstapels bestimmt sein. Im Falle einer rechteckigen Form der Leuchtfläche weist die erste Elektrode Ränder auf, die gerade und parallel sind. Bei einer von einem Rechteck abgeleiteten Freiform der Leuchtfläche weist die erste Elektrode zumindest einen oder mehrere Ränder auf, die gebogen sind. Hierbei kann die Leuchtfläche und damit auch die erste Elektrode beispielsweise immer noch vier Ecken aufweisen.

Gemäß einer weiteren Ausführungsform weist der organische funktionelle Schichtenstapel zumindest zwei organische Licht emittierende Schichten auf, die im Betrieb Licht mit unterschiedlichen Wellenlängen abstrahlen. Zwischen einer der Elektroden und den organischen Licht emittierenden Schichten können sich zumindest zwei organische funktionelle Schichten befinden, die eine Energiebarriere für Ladungsträger in Richtung der organischen funktionellen Schichten aufweisen.

Das bedeutet, dass die Ladungsträger auf ihrem Weg von der Elektrode zu den organischen Licht emittierenden Schichten die Energiebarriere überwinden müssen. Die Energiebarriere kann bevorzugt mindestens 0,1 eV betragen.

Ein organischer funktioneller Schichtenstapel mit einer Energiebarriere für Ladungsträger in Richtung der organischen funktionellen Schichten kann bewirken, dass der organische funktionelle Schichtenstapel eine Abhängigkeit der Emissionsfarbe von der angelegten Betriebsspannung hat. Die Farbe des vom organischen Licht emittierenden Bauelement abgestrahlten Lichts hängt von der Anzahl der Photonen ab, die in jeder der zumindest zwei organischen funktionellen Schichten erzeugt werden. Müssen Ladungsträger ausgehend von einer der Elektroden eine Energiebarriere in Richtung der organischen Licht emittierenden Schichten überwinden, also von der Anode in den organischen funktionellen Schichtenstapel abgegebene Löcher oder von der Kathode in den organischen funktionellen Schichtenstapel abgegebene Elektronen, so können bei einer bestimmten Betriebsspannung eine gewisse Anzahl von Ladungsträgern pro Zeit die Energiebarriere überwinden. Diese werden bevorzugt in der der Energiebarriere näher liegenden organischen Licht emittierenden Schicht mit entgegengesetzt geladenen Ladungsträgern rekombinieren, sodass in einer von der Energiebarriere weiter entfernten organischen Licht emittierenden Schicht weniger Ladungsträger zur Rekombination zur Verfügung stehen. Wird die Betriebsspannung erhöht, können mehr Ladungsträger ausgehend von der Ladungsträgerbarriere durch die nächstliegende organische Licht emittierende Schicht zu einer dahinter angeordneten organischen Licht emittierenden Schicht gelangen, sodass letztere relativ zur näher gelegenen organischen Licht emittierenden Schicht mehr Photonen erzeugen kann. Werden organische Licht emittierende Schichten mit unterschiedlichen Emissionsfarben eingesetzt, kann dadurch durch Variation der Betriebsspannung und entsprechend der Betriebsstromdichte die relative Intensität der von den organischen Licht emittierenden Schichten abgestrahlten Farben mit einer Änderung der Betriebsspannung variieren. Die Variation kann beispielsweise durch einen vorab beschriebenen Spannungsabfall in der ersten Elektrode und/oder durch eine zeitliche Variation der an das organische Licht emittierende Bauelement angelegten Betriebsspannung erreicht werden. Bei den vorab beschriebenen Verfahren zum Betrieb des organischen Licht emittierenden Bauelements kann somit zusätzlich zu einem Leuchtdichtegradienten auch ein Farbgradient erzeugt werden, da durch den oben beschriebenen Spannungsabfall in den Leiterbahnen bzw. in der ersten Elektrode neben einer Leuchtdichtevariation entsprechend auch eine Farbvariation hervorgerufen werden kann.

Mit den hier beschriebenen Verfahren kann ein gewünschter Leuchtdichtegradient in Längs- oder Querrichtung der Leuchtfläche erzeugt werden, der zeitlich und/oder räumlich variiert werden kann, ohne dass aufwändige bauliche Maßnahmen am organischen Licht emittierenden Bauelement vorzunehmen sind. Im Gegensatz hierzu gibt es im Stand der Technik einen Ansatz, bei dem die Fläche einer Elektrode wie beispielsweise der Anode an einigen Stellen nicht nur am Rand sondern auch im Zentrum kontaktiert wird. Ein entsprechendes Bauelement ist in der Druckschrift WO 2012/052886 A2 beschrieben, bei dem von der Kathode aus durch sogenanntes Laserdrilling Kontaktlöcher zur darunter liegenden Anode hergestellt werden, die dann durch Kontaktelemente kontaktiert werden. Dadurch ist es möglich, an unterschiedlichen Stellen der Anode unterschiedlich viel Strom einzubringen und folglich ungleichmäßige Homogenitäten zu erreichen. Die Herstellung von Kontakten nicht nur am Rand sondern auch auf der Fläche und beispielsweise im Zentrum einer Elektrode ist jedoch nur durch aufwändige zusätzliche Verfahrensschritte bei der Herstellung realisierbar.

Im Gegensatz zum Stand der Technik weist das organische Licht emittierende Bauelement, das bei den hier beschriebenen Verfahren verwendet wird, eine Leuchtfläche auf, die frei von elektrischen Kontakten auf der Fläche und entfernt vom Rand der Elektroden ist. Somit ist es bei dem hier beschriebenen organischen Licht emittierenden Bauelement nicht nötig, die Leuchtfläche zu strukturieren oder zusätzliche Kontakte innerhalb des Randes im Zentrum der Leuchtfläche anzubringen. Stattdessen werden Leuchtdichtegradienten und/oder Farbgradienten durch gezielt gewählte Betriebsbedingungen und gezielt gewählte Kontaktgeometrien erzeugt. Jedes der beschriebenen elektrischen Anschlusselemente speist aber in die gesamte erste Elektrode und somit in dieselbe Leuchtfläche ein.

Weitere Vorteile, vorteilhafte Ausführungsformen und Weiterbildungen ergeben sich aus den im Folgenden in Verbindung mit den Figuren beschriebenen Ausführungsbeispielen.

Es zeigen:

| Figur 1 | eine schematische Darstellung eines organischen Licht emittierenden Bauelements gemäß einem Ausführungsbeispiel, |
| Figuren 2 und 3 | schematische Darstellungen von organischen Licht emittierenden Bauelementen gemäß weiteren Ausführungsbeispielen, |
| Figur 4 | eine schematische Darstellung von Betriebsparametern bei einem Verfahren zum Betrieb eines organischen Licht emittierenden Bauelements gemäß einem weiteren Ausführungsbeispiel, |
| Figuren 5 bis 14 | schematische Darstellung von organischen Licht emittierenden Bauelementen oder Kontaktierungen dieser gemäß weiteren Ausführungsbeispielen und |
| Figuren 15 bis 17 | schematische Darstellungen eines organischen Licht emittierende Bauelements sowie von Energiezuständen in organischen funktionellen Schichten beim Betrieb von organischen Licht emittierenden Bauelementen gemäß weiteren Ausführungsbeispielen. |

In den Ausführungsbeispielen und Figuren können gleiche, gleichartige oder gleich wirkende Elemente jeweils mit denselben Bezugszeichen versehen sein. Die dargestellten Elemente und deren Größenverhältnisse untereinander sind nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben groß dargestellt sein.

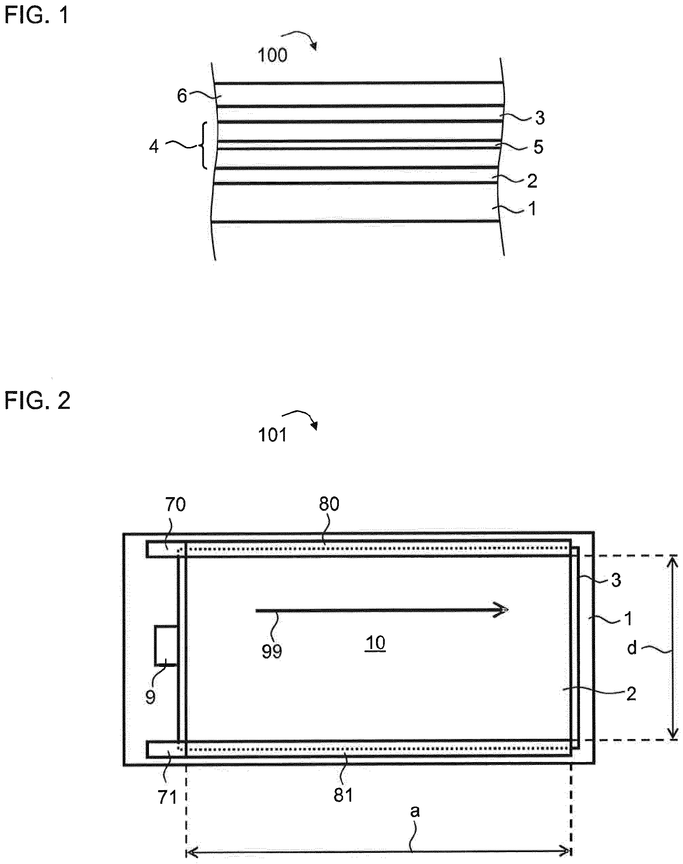

In Figur 1 ist ein Ausschnitt des Schichtaufbaus eines organischen Licht emittierenden Bauelements 100 gemäß einem Ausführungsbeispiel gezeigt. Der Aufbau des organischen Licht emittierenden Bauelements 100 ist rein beispielhaft und nicht beschränkend für die nachfolgenden Ausführungsbeispiele zu verstehen.

Das organische Licht emittierende Bauelement 100 ist als organische Licht emittierende Diode (OLED) ausgebildet und weist zwischen einer ersten Elektrode 2 und einer zweiten Elektrode 3 einen organischen funktionellen Schichtenstapel 4 mit zumindest einer organischen Licht emittierenden Schicht 5 auf. Die Elektroden 2, 3 und der organische funktionelle Schichtenstapel 4 sind auf einem Substrat 1 angeordnet. Im gezeigten Ausführungsbeispiel ist das Substrat 1 transparent ausgeführt, beispielsweise in Form einer Glasplatte oder Glasschicht. Über dieser ist die erste Elektrode 2 aufgebracht, die beispielsweise ein transparentes leitendes Oxid wie etwa ITO oder ein anderes oben im allgemeinen Teil für die erste Elektrode genanntes Material aufweist.

Die zweite Elektrode 3 ist im gezeigten Ausführungsbeispiel reflektierend ausgebildet und weist insbesondere ein oben im allgemeinen Teil beschriebenes Metall, beispielsweise Ag und/oder Al, auf. Insbesondere können die erste Elektrode 2 als Anode und die zweite Elektrode 3 als Kathode oder umgekehrt ausgebildet sein.

Insbesondere sind die Materialien und die Dicken der ersten Elektrode 2 und der zweiten Elektrode 3 so gewählt, dass die erste Elektrode 2 einen höheren elektrischen Flächenwiderstand als die zweite Elektrode 3 aufweist. Für die nachfolgend beschriebenen Ausführungsbeispiele ist es besonders vorteilhaft, wenn die erste Elektrode 2 einen um mindestens zehnmal und bevorzugt einen um mindestens hundertmal größeren elektrischen Flächenwiderstand als die zweite Elektrode 3 aufweist.

Das organische Licht emittierende Bauelement 100 ist im gezeigten Ausführungsbeispiel als Bottom-Emitter ausgeführt und strahlt im Betrieb Licht, das in der zumindest einen organischen funktionellen Schicht 5 erzeugt wird, durch die transparent ausgebildete erste Elektrode 2 und das transparente Substrat 1 ab. Beispielsweise ist es aber auch möglich, dass das organische Licht emittierende Bauelement 100 anstelle der gezeigten Bottom-Emitter-Konfiguration als Top-Emitter oder als transparentes, beidseitig emittierendes organisches Licht emittierendes Bauelement ausgebildet ist, wie oben im allgemeinen Teil beschrieben ist.

Der organische funktionelle Schichtenstapel 4 mit der zumindest einen organischen Licht emittierenden Schicht 5 weist weiterhin beispielsweise eine oder mehrere organische funktionelle Schichten ausgewählt aus Lochinjektionsschichten, Löchertransportschichten, Elektronenblockierschichten, Löcherblockierschichten, Elektronentransportschichten und Elektroneninjektionsschichen auf, die geeignet sind, Löcher und Elektronen zur zumindest einen organischen Licht emittierenden Schicht 5 zu leiten oder den jeweiligen Transport zu blockieren. Weiterhin ist es auch möglich, dass mehrere Licht emittierende Schichten vorhanden sind. Geeignete Schichtaufbauten für den organischen funktionellen Schichtenstapel 4 sind dem Fachmann bekannt und werden daher hier nicht weiter ausgeführt.

Auf der zweiten Elektrode 3 ist eine Verkapselungsschicht 6 angeordnet. Diese kann, wie in Figur 1 gezeigt ist, beispielsweise unmittelbar auf der zweiten Elektrode 3 aufgebracht sein. Weiterhin ist es auch möglich, dass zwischen der zweiten Elektroden 3 und der Verkapselungsschicht 6 weitere Schichten, beispielsweise Zwischen- oder Schutzschichten, angeordnet sind oder ein Bereich vorgesehen ist, in dem sich ein Gas, ein Gel oder eine Flüssigkeit befindet. Insbesondere kann die Verkapselungsschicht 6 beispielsweise als Dünnfilm-Verkapselung ausgebildet sein, die eine oder eine Mehrzahl von dünnen Schichten aufweist, die für sich alleine genommen oder zumindest zusammen eine möglichst hermetisch dichte Verkapselung des organischen funktionellen Schichtenstapels 4 und der Elektroden 2, 3 gegenüber schädigenden Substanzen bewirken kann. Derartige Verkapselungsschichten sind beispielsweise in den Druckschriften US 2011/0121354 A1, US 2011/0114992 A1 und US 2011/0049730 A1 beschrieben. Alternativ hierzu ist es auch möglich, dass die Verkapselungsschicht beispielsweise durch eine Glasschicht, beispielsweise eine Glasplatte oder einen Glasdeckel, gebildet wird, die über dem organischen funktionellen Schichtenstapel 4 und den Elektronen 2, 3 auf dem Substrat 1 aufgebracht ist. Die Glasschicht kann eine Kavität über den Elektroden 2, 3 und dem organischen funktionellen Schichtenstapel 4 bilden, in dem ein Getter-Material zur Absorption von schädigenden Substanzen angeordnet sein kann.

Die in den nachfolgenden Ausführungsbeispielen gezeigten organischen Licht emittierenden Bauelemente können rein beispielhaft einen in Figur 1 gezeigten Schichtaufbau aufweisen. Bezugzeichen und Verweise auf einzelne Schichten eines organischen Licht emittierenden Bauelements können sich daher zusätzlich auch auf den in Figur 1 gezeigten und beschriebenen Aufbau beziehen.

In Figur 2 ist ein organisches Licht emittierendes Bauelement 101 gemäß einem weiteren Ausführungsbeispiel gezeigt, das für ein im Folgenden beschriebenes Verfahren verwendet wird. Die Darstellung des Bauelements 101 entspricht einem Blick auf die Leuchtfläche 10 des Bauelements 101, also einer Aufsicht auf das Bauelement 101. Im Falle eines Bottom-Emitters, wie er in Verbindung mit Figur 1 beschrieben ist, entspricht die Darstellung des organischen Licht emittierenden Bauelements 101 in Figur 2 einem Blick auf die dem organischen funktionellen Schichtenstapel 4 abgewandte Seite des Substrats 1 bzw. durch das Substrat 1 hindurch auf die darüber angeordneten Schichten.

Zusätzlich zu den Elektroden 2 und 3 und dem organischen funktionellen Schichtenstapel zwischen diesen weist das organische Licht emittierende Bauelement 101 auf dem Substrat 2 Leiterbahnen 80, 81 auf, die in Kontakt mit der ersten Elektrode 2 stehen und sich an zwei gegenüberliegenden Rändern der ersten Elektrode jeweils in eine Längsrichtung entlang des jeweiligen Randes erstrecken, die der Richtung des Pfeils 99 entspricht. Insbesondere erstrecken sich die Leiterbahnen 80, 81 jeweils über den gesamten Rand der ersten Elektrode 2, sodass die Leiterbahnen 80, 81 die erste Elektrode 2 jeweils über die gesamte mit a bezeichnete Länge kontaktieren, die der Länge der Leuchtfläche 10 entspricht. Quer zur Längsrichtung weisen die Leiterbahnen 80, 81 einen Abstand d auf, der der Breite der Leuchtfläche 10 entspricht.

Die Leiterbahnen weisen einen Flächenwiderstand von größer oder gleich 40 mΩ/sq und kleiner oder gleich 100 mΩ/sq und bevorzugt von etwa 70 mΩ/sq auf. Dabei weisen die Leiterbahnen 80, 81 beispielsweise Cu, Cr, Al und/oder Mo auf. Beispielsweise können die Leiterbahnen 80, 81 auch aus einer Schichtkombination mit mehreren Materialien, beispielsweise Cr/Al/Cr oder Mo/Al/Mo gebildet werden. Die beiden lateral in kontinuierlichem Kontakt zur ersten Elektrode 2 und damit zur aktiven Fläche des organischen Licht emittierenden Bauelements 101 stehenden Leiterbahnen 80, 81 weisen eine typische Breite von etwa 2 mm auf. Die Länge a des aktiven Bereichs und damit auch der Leuchtfläche 10 beträgt vorzugsweise zwischen 15 und 25 cm. Der Flächenwiderstand R der ersten Elektrode 2 beträgt vorzugsweise 1 Ω/sq ≤ R ≤ 20 Ω/sq und bevorzugt etwa 15 Ω/sq.

Weiterhin sind auf dem Substrat 1 Anschlusselemente 70, 71 zur elektrischen Kontaktierung der Leiterbahnen 80, 81 angeordnet, wobei die Leiterbahnen 80, 81 auf einer selben Seite der ersten Elektrode 2 mittels der Anschlusselemente 70, 71 kontaktiert werden. Alternativ zu zwei getrennt angeordneten Anschlusselementen 70, 71 kann auch ein beide Leiterbahnen 80, 81 gemeinsam kontaktierendes Anschlusselement vorgesehen sein. Die Anschlusselemente 70, 71 und die jeweils zugehörige Leiterbahn 80, 81 können beispielsweise einstückig ausgebildet sein, sodass die elektrischen Anschlusselemente 70, 71 zumindest teilweise durch das gleiche Material wie die Leiterbahnen 80, 81 gebildet sein können. Alternativ hierzu können die Anschlusselemente 70, 71 auch durch ein anderes Material als die Leiterbahnen 80, 81 gebildet werden. Beispielsweise können die elektrischen Anschlusselemente Kontaktflächen für Bondkontakte, Lötkontakte, elektrisch leitende Klebkontakte oder Steckkontakte bilden. Weiterhin ist es auch möglich, dass die Anschlusselemente 70, 71 über elektrische Leiterbahnen, die auf dem Substrat 1 verlaufen können, und/oder durch elektrische Vias, die sich durch das Substrat 1 hindurch erstrecken können, elektrisch kontaktiert werden, sodass ein elektrischer Anschluss der ersten Elektrode 2 unabhängig von der konkreten Lage der elektrischen Anschlusselemente 70, 71 und der Leiterbahnen 80, 81 beispielsweise an einer oder mehreren Seitenkanten oder einer Rückseite des Substrats 1 erfolgen kann.

Die zweite Elektrode 3 kann durch ein weiteres Anschlusselement 9 kontaktiert werden, das beispielsweise von der ersten Elektrode 2 aus gesehen auf derselben Seite wie die Anschlusselemente 70, 71 für die Leiterbahnen 80, 81 angeordnet ist. Da die zweite Elektrode 3 vorzugsweise eine deutlich höhere Leitfähigkeit und damit einen deutlich niedrigeren Flächenwiderstand als die erste Elektrode 2 aufweist, kann die elektrische Kontaktierung der zweiten Elektrode 3 auch von einer oder mehreren anderen Seiten und/oder mit mehreren Anschlusselementen erfolgen.

Aufgrund des Flächenwiderstands der Leiterbahnen 80, 81 liegt in jeder Leiterbahn 80, 81 im Betrieb des organischen Licht emittierenden Bauelements 101 ein Spannungsabfall entlang der Längsrichtung vor. Mit steigendem Abstand zu den Anschlusselementen 70, 71 in Längsrichtung sinkt somit die lokale Betriebsspannung im Bereich der Leuchtfläche 10, sodass in den organischen funktionellen Schichtstapel 4 mit zunehmendem Abstand zu den Anschlusselementen 70, 71 ein geringerer lokaler Betriebsstrom bzw. eine geringere lokale Betriebsstromdichte eingeprägt wird. Hierdurch wird ein mit dem Pfeil angedeuteter Leuchtdichtegradient 99 auf der Leuchtfläche 10 in Richtung entlang der Längsrichtung bewirkt.

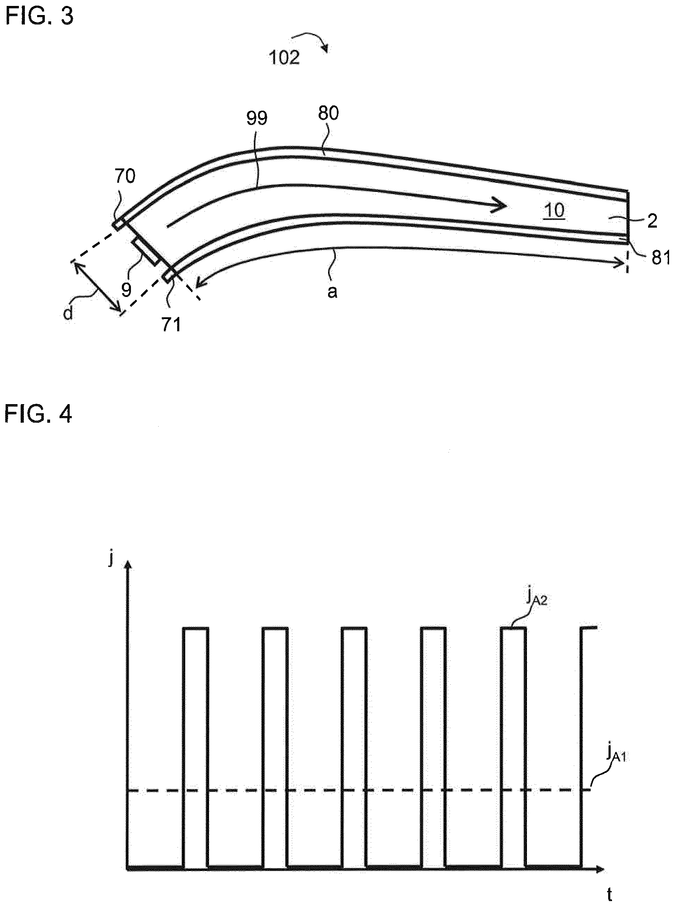

In Figur 3 ist ein weiteres Ausführungsbeispiel für ein organisches Licht emittierendes Bauelement 102 gezeigt, das im Vergleich zum organischen Licht emittierenden Bauelement 101 der Figur 2 eine von der Rechtecksform des Bauelements 101 abgeleitete Freiform aufweist, wobei das Substrat 1 nicht gezeigt ist. Die in Figur 3 gezeigten Elemente und Abmessungen entsprechen denen des Bauelements 101 der Figur 2.

Die nachfolgende Beschreibung bezüglich eines Verfahrens zum Betrieb eines organischen Licht emittierenden Bauelements bezieht sich gleichermaßen auf die organischen Licht emittierenden Bauelemente 101 und 102 der Figuren 2 und 3.

Das organische Licht emittierende Bauelement 101, 102 weist eine Kennlinie r = dV/dj auf, wie oben im allgemeinen Teil beschrieben ist.

Zum Betrieb des Bauelements 101, 102 wird ein Arbeitspunkt r = $r_A$ so gewählt, dass gilt: 0,75 ≤ U ≤ 1, mit U = 1 - (1 - H) / (1 + H), H = $\cosh^{-1}$ (L/A) und A = $(r/R)^{0,5}$, wobei L = 0,5 × d und R der vorab beschriebene Flächenwiderstand der ersten Elektrode 2 ist. Besonders bevorzugt kann der Arbeitspunkt r = $r_A$ auch so gewählt werden, dass U = 0,8.

Dem so bestimmten Arbeitspunkt ist eine Stromdichte $j_A$ zugeordnet, die der mittleren Stromdichte entspricht, die über die aktive Fläche des Bauelements 101, 102, also über die Leuchtfläche 10, im Betrieb vorliegt. Dadurch kann eine akzeptable Homogenität in Querrichtung, also senkrecht zur Längsrichtung entlang des Pfeils 99, erreicht werden bei gleichzeitiger Maximierung eines Leuchtdichtegradienten 99 in Längsrichtung. Um eine gewünschte Helligkeit der Leuchtfläche 10 einzustellen, wird das organische Licht emittierende Bauelement 101, 102 anstelle eines konstanten Betriebsstroms mit einem mittels Pulsweitenmodulation modulierten Betriebsstrom betrieben, wobei der dem Arbeitpunkt $r_A$ zugeordnete Betriebsstrom und somit die zugeordnete über die Leuchtfläche gemittelte Betriebsstromdichte $j_A$ als Amplitude des PWM-Signals beibehalten wird.

In einer weiteren Ausführungsform des Verfahrens, die in Verbindung mit Figur 4 beschrieben ist, ist es auch möglich, die Leuchtdichte der Leuchtfläche 10 konstant zu halten, während der Leuchtdichtegradient 99 entlang der Längsrichtung variiert wird. Hierzu können ein erster Arbeitspunkt r = $r_{A1}$ mit einer zugehörigen Betriebsstromdichte $j_{A1}$ und ein zweiter Arbeitspunkt r = $r_{A2}$ mit einer entsprechenden Betriebsstromdichte $j_{A2}$ gewählt werden, wobei gilt: $j_{A2}$ > $j_{A1}$. Für die Arbeitspunkte r = $r_{A1}$ und r = $r_{A2}$ gilt jeweils 0,75 ≤ U ≤ 0,95.

Bei der höheren Betriebsstromdichte $j_{A2}$ beim zweiten Arbeitspunkt r = $r_{A2}$ liegt ein stärkerer Spannungsabfall entlang der Längsrichtung in den Leiterbahnen 80, 81 vor, sodass hierdurch ein größerer Leuchtdichtegradient erreicht wird als beim Betrieb beim ersten Arbeitspunkt r = $r_{A1}$ mit einer Betriebsstromdichte $j_{A1}$. Um die Helligkeit der Leuchtfläche 10, also die gesamte Leuchtdichte der Leuchtfläche 10, bei beiden Arbeitspunkten gleich zu halten, wird zumindest beim zweiten Arbeitspunkt r = $r_{A2}$ der Betriebsstrom mittels Pulsweitenmodulation so moduliert, dass die mittlere Betriebsstromdichte im zeitlichen Mittel der Betriebsstromdichte $j_{A1}$ im ersten Arbeitspunkt $r = r_{A1}$ entspricht. Im ersten Arbeitspunkt $r = r_{A1}$ kann z. B. auch ein konstanter Strom mit einer Betriebsstromdichte $j_{A1}$ angelegt werden. Entsprechende Betriebsstromdichten $j_{A1}$ und $j_{A2}$ sind hinsichtlich ihres zeitlichen Verlaufs in Figur 4 gezeigt. Durch eine Änderung der Betriebsstromdichte $j$ zwischen den beiden Arbeitspunkten $r_{A1}$ und $r_{A2}$, also für Betriebsstromdichten $j_{A1} < j < j_{A2}$ kann der Leuchtdichtegradient 99 variiert werden. Durch eine beschriebene geeignete Pulsweitenmodulation des Betriebsstroms kann dabei die Helligkeit der Leuchtfläche unabhängig vom Leuchtdichtegradienten 99 konstant gehalten werden.

Bei einem Flächenwiderstand $R = 15\ \Omega/sq$ der ersten Elektrode 2 und einer Bauteilbreite von $d = 2,8\ cm$ werden beispielsweise der erste Arbeitspunkt $r = r_{A1} = 70\ \Omega cm^2$ und der zweite Arbeitspunkt $r = r_{A2} = 35\ \Omega cm^2$ gewählt. Entsprechend der vorgenannten Formeln ergibt sich daraus beim ersten Arbeitspunkt $r = r_{A1}$ für $A = 2,16$, $H = 0,82$ und $U = 0,92$, während sich für den zweiten Arbeitspunkt $r = r_{A2}$ die Werte $A = 1,53$, $H = 0,69$ und $U = 0,80$ ergeben.

Am ersten Arbeitspunkt $r = r_{A1}$ ist somit $U = 0,92$ während bei erhöhten Betriebsbedingungen beim zweiten Arbeitspunkt $r = r_{A2}$ $U$ etwa $0,8$ beträgt. Da im zweiten Arbeitspunkt der Spannungsabfall über die Leuchtfläche deutlich höher als im ersten Arbeitspunkt ist, wird im zweiten Arbeitspunkt ein stärkerer Leuchtdichtegradient erreicht. Wie vorab beschrieben, kann über Pulsweitenmodulation die mittlere Leuchtdichte der Leuchtfläche 10 so geregelt werden, dass in beiden Arbeitspunkten sowie auch bei Arbeitspunkten, die zwischen $r_{A1}$ und $r_{A2}$ liegen, eine konstante Leuchtdichte der Leuchtfläche 10 erreicht wird. Die in Verbindung mit den Figuren 2 bis 4 beschriebenen Zahlenwerte sind rein beispielhaft und nicht beschränkend zu verstehen.

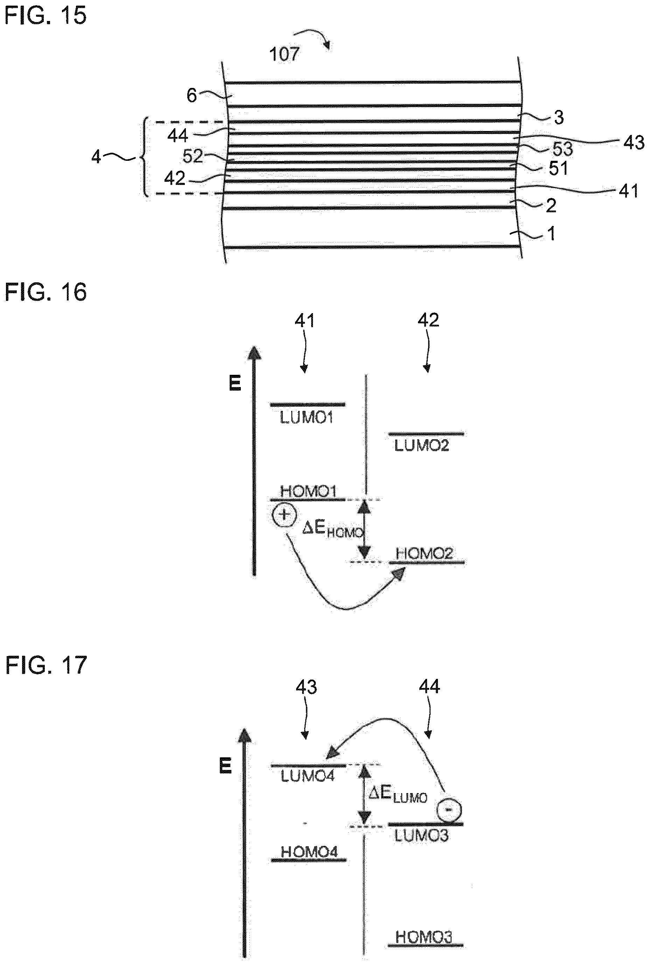

Soll zusätzlich zu einem Leuchtdichtegradienten auch ein Farbgradient erreicht werden, kann ein organisches Licht emittierendes Bauelement gewählt werden, der eine ausgeprägte Abhängigkeit der Emissionsfarbe von der Spannung aufweist, wie er in Verbindung mit den Figuren 15 bis 17 beschrieben ist. Soll hingegen nur ein Leuchtdichtegradient erzielt werden, ist ein organischer funktioneller Schichtenstapel zu wählen, der eine geringe Abhängigkeit der Emissionsfarbe von der anliegenden Spannung bzw. von der Betriebsstromdichte zeigt.

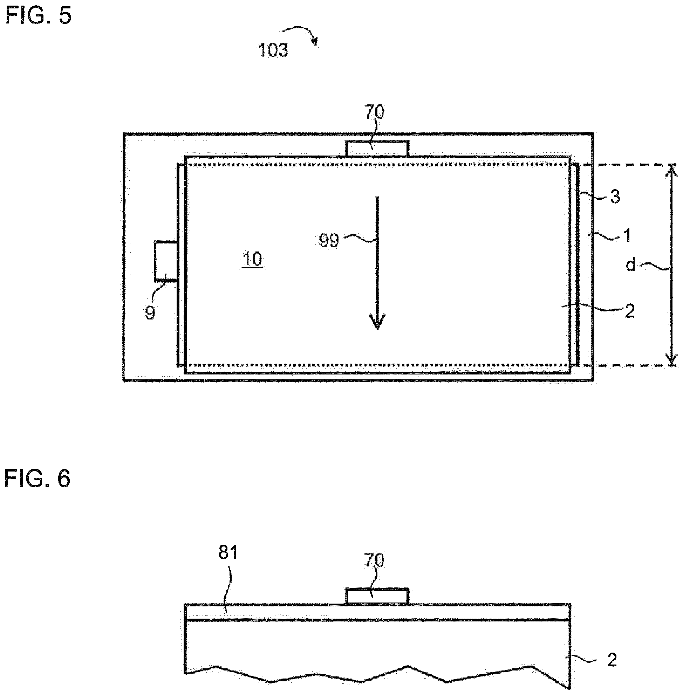

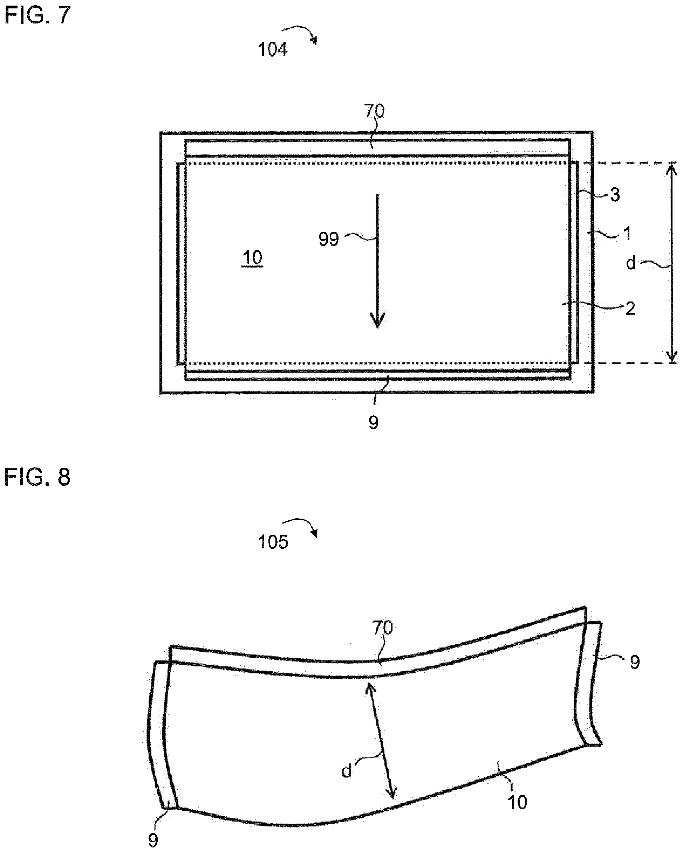

In Verbindung mit den Figuren 5 bis 14 sind organische Licht emittierende Bauelemente und Verfahren zum Betrieb dieser beschrieben, die anstelle eines Leuchtdichtegradienten in Längsrichtung einen Leuchtdichtegradienten in Querrichtung aufweisen, wie beispielsweise in den Figuren 5 und 7 mit Hilfe des Pfeils 99 angedeutet ist. Die Beschreibung der nachfolgenden Figuren bezieht sich hauptsächlich auf die Unterschiede zu den vorherigen Ausführungsbeispielen.

In Figur 5 ist ein Ausführungsbeispiel für ein organisches Licht emittierendes Bauelement 103 gezeigt, bei dem im Vergleich zu dem vorherigen Ausführungsbeispiel ein Leuchtdichtegradient nicht in Längsrichtung sondern in Querrichtung erzeugt wird, wie mit dem Pfeil 99 in Figur 5 angedeutet ist. Im Vergleich zu dem vorherigen Ausführungsbeispiel weist das organische Licht emittierende Bauelement 103 zumindest ein erstes elektrisches Anschlusselement 70 an einem Rand der ersten Elektrode 2 auf. Bei dem Rand der ersten Elektrode handelt es sich um einen Rand in Längsrichtung, an dem das zumindest eine erste Anschlusselement 70, wie in Figur 5 gezeigt ist, beispielsweise mittig angeordnet sein kann.

Die zweite Elektrode 3 kann mittels eines weiteren elektrischen Anschlusselements 9 wie im vorherigen Ausführungsbeispiel kontaktiert werden, wobei aufgrund einer deutlich höheren Leitfähigkeit der zweiten Elektrode 3 im Vergleich zur ersten Elektrode 2 das Anschlusselement 9 wie in Figur 5 gezeigt an einer Randseite entlang der Querrichtung oder auch an einer anderen Randseite der zweiten Elektrode 3 angeordnet sein kann, wie in den Figuren 7 bis 9 gezeigt ist.

Die erste Elektrode 2 weist wie schon in dem vorherigen Ausführungsbeispiel einen Flächenwiderstand $R$ mit $0,4\ \Omega/sq \leq R \leq 100\ \Omega/sq$ auf. Beispielsweise kann die erste Elektrode 2 im gezeigten Ausführungsbeispiel einen Flächenwiderstand $R = 2,5\ \Omega/sq$ aufweisen. In Querrichtung weist die Leuchtfläche 10 eine Breite $d$ auf, wobei $d$ im gezeigten Ausführungsbeispiel 5 cm ist.

Aufgrund des elektrischen Flächenwiderstands der ersten Elektrode liegt beim Betrieb des organischen Licht emittierenden Bauelements 103 entlang einer von zumindest einem ersten elektrischen Anschlusselement 70 wegführenden Richtung ein Spannungsabfall vor, der einen Leuchtdichtegradienten 99 auf der Leuchtfläche 10 entlang dieser Richtung bewirkt.

Wie bereits in Verbindung mit dem vorherigen Ausführungsbeispiel beschrieben, weist das organische Licht emittierende Bauelement 103 eine Kennlinie $r$ mit $r = dV/dj$ auf.

Zum Betrieb des organischen Licht emittierenden Bauelements 103 wird ein Arbeitspunkt $r = r_A$ so gewählt, dass gilt: $U \leq 0,2$, mit $U = 1 - (1 - H)/(1 + H)$, $H = \cosh^{-1}(L/\Lambda)$ und $A = (r/R)^{0,5}$, wobei $L = D$ gilt. Dem Arbeitspunkt $r = r_A$ entspricht eine Betriebsstromdichte $j_A$, bei der ein ausgeprägter Leuchtdichtegradient 99 in der in Figur 5 gezeigten Querrichtung erzeugt werden kann. Zum Betrieb des organischen Licht emittierenden Bauelements 103 kann die Betriebsstromdichte $j_A$ in Form eines Konstantstroms in die organische funktionelle Schichtenfolge 4 eingespeist werden. Um die Helligkeit des organischen Licht emittierenden Bauelements 103, also die Gesamtleuchtdichte, einzustellen, die von der Leuchtfläche 10 abgestrahlt wird, kann wie in Verbindung mit den vorherigen Ausführungsbeispielen beschrieben ein Betriebsstrom auch mittels Pulsweitenmodulation moduliert in den organischen funktionellen Schichtenstapel eingespeist werden. Der Maximalstrom des PWM-Signals, also die Amplitude des gepulsten Betriebsstroms, wird so gewählt, dass über die aktive Fläche, also die Leuchtfläche 10, des organischen Licht emittierenden Bauelements 103 gemittelt die dem Arbeitspunkt r = $r_A$ entsprechende Betriebsstromdichte $j_A$ vorliegt.

Weiterhin kann beim Betrieb des organischen Licht emittierenden Bauelements 103 auch die Stärke des Leuchtdichtegradienten 99 moduliert werden, während die gesamte Leuchtdichte des von der Leuchtfläche 10 abgestrahlten Lichts konstant gehalten wird. Mit anderen Worten wird die Gesamthelligkeit des organischen Licht emittierenden Bauelements 103 konstant gehalten, während die Stärke des Leuchtdichtegradienten 99 über die Leuchtfläche 10 variiert beziehungsweise moduliert wird. Dies kann dadurch erreicht werden, dass beispielsweise wie vorab beschrieben ein Arbeitspunkt r = $r_{A1}$ gewählt wird, bei dem ein ausgeprägter Leuchtdichtegradient 99 vorliegt. Das organische Licht emittierende Bauelement 103 wird mit einem gepulsten Betriebsstrom mit einer Betriebsstromdichtenamplitude betrieben, die der Betriebsstromdichte $j_{A1}$ beim Arbeitspunkt r = $r_{A1}$ entspricht. Die Pulsweite des PWM-Signals wird so gewählt, dass über die Leuchtfläche 10 Licht mit einer gewünschten Helligkeit abgestrahlt wird. Durch eine Variation der Amplitude des PWM-Signals durch Wahl eines zweiten Arbeitspunkts r = $r_{A2}$, bei dem ein anderer Leuchtdichtegradient 99 erzielt wird, kann die Stärke des Leuchtdichtegradienten 99 variiert werden, wobei bei einer Änderung der Betriebsstromdichtenamplitude des PWM-Signals die Pulslänge so angepasst wird, dass über die Leuchtfläche 10 gemittelte verschiedene Betriebsstromdichten im zeitlichen Mittel gleich sind.

Weiterhin ist es auch möglich, beispielsweise zwischen einem Zustand mit einem Leuchtdichtegradienten 99 und einem Zustand ohne einen Leuchtdichtegradienten 99 auf der Leuchtfläche zu modulieren. Hierzu wird ein erster Arbeitspunkt r = $r_{A1}$ mit einer entsprechenden Betriebsstromdichte $j_{A1}$ gewählt, für den U ≥ 0,8 gilt und bei dem kein Leuchtdichtegradient auf der Leuchtfläche 10 erkennbar ist, während ein zweiter Arbeitspunkt r = $r_{A2}$ mit einer entsprechenden Betriebsstromdichte $j_{A2}$ gewählt wird, für den U ≤ 0,2 gilt und bei dem ein Leuchtdichtegradient 99 erkennbar ist. analog zum in Verbindung mit Figur 4 beschriebenen Verfahren kann durch eine Variation der über die Leuchtfläche gemittelten Betriebsstromdichte j mit $j_{A1}$ ≤ j ≤ $j_{A2}$ zwischen den beiden den Arbeitspunkten r = $r_{A1}$ und r = $r_{A2}$ variiert werden, sodass zwischen einem sichtbaren Gradienten 99 und keinem sichtbaren Gradienten 99 auf der Leuchtfläche 10 variiert werden kann. Die mittlere Leuchtdichte wird wie vorab beschrieben dabei über das PWM-Signal geregelt.

Bei einem Flächenwiderstand R = 2,5 Ω/sq der ersten Elektrode 2 und einer Bauteilbreite von d = 5 cm werden beispielsweise der erste Arbeitspunkt r = $r_{A1}$ = 70 Ωcm$^2$ und der zweite Arbeitspunkt r = $r_{A2}$ = 5 Ωcm$^2$ gewählt. Entsprechend der vorgenannten Formeln ergibt sich daraus beim ersten Arbeitspunkt r = $r_{A1}$ für A = 5,29, H = 0,68 und U = 0,81, während sich für den zweiten Arbeitspunkt r = $r_{A2}$ die Werte A = 1,41, H = 0,06 und U = 0,11 ergeben. Die angegebenen Zahlenwerte sind rein beispielhaft und nicht beschränkend zu verstehen.

In Figur 6 ist ein weiteres Ausführungsbeispiel für eine Kontaktierung der ersten Elektrode 2 mittels zumindest eines ersten Anschlusselements 70 gezeigt, wobei hier eine Leiterbahn 80 bevorzugt ohne Unterbrechungen auf dem gesamten Randbereich des kontaktierten Randes der ersten Elektrode 2 angeordnet ist, sodass der über das Anschlusselement 70 eingespeiste Betriebsstrom über die gesamte Längsseite in die zweite Elektrode eingespeist werden kann.

In Figur 7 ist ein weiteres Ausführungsbeispiel für ein organisches Licht emittierendes Bauelement 104 gezeigt, bei dem das elektrische Anschlusselement 70 so ausgebildet ist, dass es sich über die gesamte Längsseite der ersten Elektrode 2 erstreckt. Rein beispielhaft ist das elektrische Anschlusselement 9 zur Kontaktierung der zweiten Elektrode 3 auf der gegenüberliegenden Seite in elektrischem Kontakt mit der zweiten Elektrode 3 angeordnet.

Alternativ zu den in den Figuren 5 bis 7 gezeigten rechteckigen Ausbildungen des organischen Licht emittierenden Bauelements und insbesondere der Leuchtfläche 10 kann die Leuchtfläche 10 auch eine von einem Rechteck abgeleitete Freiform aufweisen, wie in den Figuren 8 und 9 gezeigt ist. In diesen Figuren sind der Übersichtlichkeit halber lediglich die Leuchtfläche 10 sowie die elektrischen Anschlusselemente 70 und 9 zur Kontaktierung der ersten und zweiten Elektrode gezeigt.

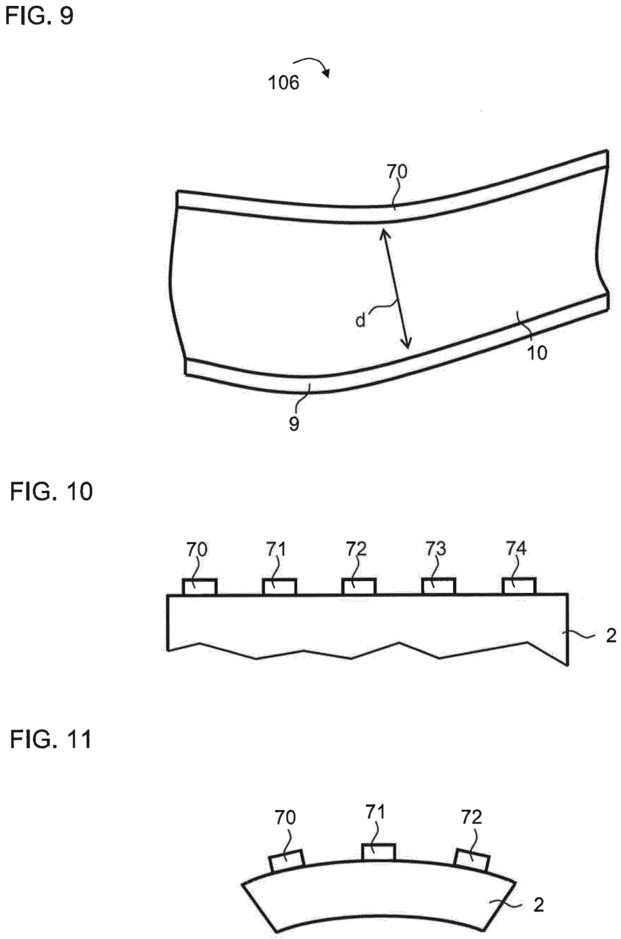

Anstelle nur eines ersten elektrischen Anschlusselements 70 zur Kontaktierung der ersten Elektrode kann das bei dem beschriebenen Verfahren verwendete organische Licht emittierende Bauelement auch beispielsweise eine Mehrzahl von elektrischen Anschlusselementen 70 bis 74 aufweisen, die entlang einer Längsseite der ersten Elektrode 2 und damit der Leuchtfläche 10 angeordnet sind, wie in Figur 10 gezeigt ist. Hierdurch kann ausgehend von jedem der Anschlusselemente 70 bis 74 ein Leuchtdichtegradient in Querrichtung erzeugt werden. Zusätzlich kann eine Modulation der Leuchtdichte in Längsrichtung durch eine zeitliche Variation der Potentiale an den unterschiedlichen elektrischen Anschlusselementen beispielsweise durch eine variable Pulsweitenmodulation, die abhängig von den Anschlusselementen jeweils einen gewählten Betriebsstrom einspeist, erzeugt werden.

Wie in Figur 11 gezeigt ist, kann die erste Elektrode 2 und damit auch die Leuchtfläche eine von einem Rechteck abgeleitete Freiform aufweisen.

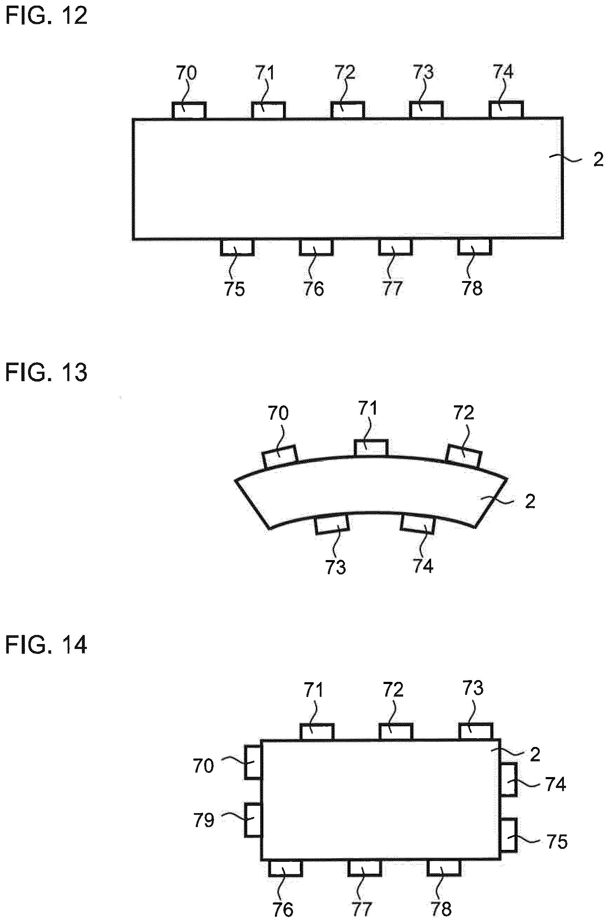

Wie in den Figuren 12 bis 14 gezeigt ist, können auch an verschiedenen Seiten jeweils eines oder eine Mehrzahl von elektrischen Anschlusselementen zur Kontaktierung der ersten Elektrode 2 angeordnet sein, wobei die elektrischen Anschlusselemente 70 bis 79 beispielsweise an zwei sich gegenüberliegenden Längsseiten angeordnet sein können, wie in den Figuren 12 und 13 gezeigt ist, oder auch an allen Rändern der ersten Elektrode 2, wie in der Figur 14 gezeigt ist.

Die Kontaktierung der zweiten Elektrode 3 kann entsprechend auch über eine Mehrzahl von elektrischen Anschlusselementen oder auch nur über ein elektrisches Anschlusselement erfolgen.

Wird zusätzlich zu den Leuchtdichtegradienten, wie sie mit den Verfahren erzeugbar sind, die in Verbindung mit den vorherigen Ausführungsbeispielen beschrieben sind, auch ein Farbgradient über die Leuchtfläche 10 erwünscht, ist es erforderlich, ein organisches Licht emittierendes Bauelement zu verwenden, das eine strom- beziehungsweise spannungsabhängige Emissionsfarbe aufweist. In Verbindung mit den Figuren 15 bis 17 ist ein entsprechendes organisches Licht emittierendes Bauelement 107 beschrieben, das in Abhängigkeit der angelegten Betriebsspannung und damit der eingespeisten Betriebsstromdichte unterschiedliche Emissionsfarben zeigt. Dadurch, dass der Leuchtdichtegradient, wie er in Verbindung mit den vorherigen Ausführungsbeispielen beschrieben ist, über einen Spannungsabfall in einer Längs- oder Querrichtung der ersten Elektrode 2 erzeugt wird, kann bei einem entsprechenden organischen Licht emittierenden Bauelement zusätzlich zum Leuchtdichtegradient auch ein Farbgradient erzeugt werden.

Wie in Figur 15 gezeigt ist, kann das organische Licht emittierende Bauelement 107 hierzu einen organischen funktionellen Schichtenstapel 4 aufweisen, der im Vergleich zum organischen Licht emittierenden Bauelement 100 der Figur 1 eine Mehrzahl von organischen Licht emittierenden Schichten 51, 52, 53 aufweist. Möglich sind auch andere Anordnungen mit einer geänderten Anzahl von organischen Licht emittierenden Schichten und/oder mit einer oder mehreren Zwischenschichten zwischen den organischen Licht emittierenden Schichten. Anstelle der in Figur 15 beispielhaft gezeigten drei Licht emittierenden Schichten können beispielsweise auch nur zwei oder auch mehr als drei Licht emittierende Schichten im organischen funktionellen Schichtenstapel 4 vorhanden sein. Rein beispielhaft sind die organischen Licht emittierenden Schichten 51 bis 53 so ausgebildet, dass die organische Licht emittierende Schicht 51 im Betrieb rotes Licht, die organische Licht emittierende Schicht 52 im Betrieb grünes Licht und die organische Licht emittierende Schicht 53 im Betrieb blaues Licht abstrahlen.

Weiterhin weist der organische funktionelle Schichtenstapel des organischen Licht emittierenden Bauelements 107 zumindest zwei organische funktionelle Schichten 41, 42 und/oder 43, 44 auf, die zwischen einer der Elektroden 2, 3 und den organischen Licht emittierenden Schichten 51, 52, 53 angeordnet sind und die eine Energiebarriere für Ladungsträger in Richtung der organischen Licht emittierenden Schichten 51, 52, 53 ausbilden. Obwohl im gezeigten Ausführungsbeispiel der Figur 15 auf beiden Seiten entsprechende organische funktionelle Schichten 41, 42 und 43, 44 gezeigt sind, ist es besonders vorteilhaft, dass solche Schichten, die eine Energiebarriere für Ladungsträger in Richtung der organischen Licht emittierenden Schichten 51, 52, 53 ausbilden, nur auf einer Seite von den organischen Licht emittierenden Schichten 51, 52, 53 aus gesehen angeordnet sind.

Rein beispielhaft ist die erste Elektrode 2 im gezeigten Ausführungsbeispiel als Anode und damit als löcherinjizierende Schicht ausgebildet, während die zweite Elektrode 3 als Kathode und damit als elektroneninjizierende Schicht ausgebildet ist. Dementsprechend sind die Schichten 41, 42 als löcherleitende Schichten und die Schichten 43, 44 als elektronenleitende Schichten ausgebildet. Um eine spannungs- beziehungsweise stromabhängige Emissionsfarbe des organischen funktionellen Schichtenstapels 4 zu erreichen, ist es erforderlich, dass die organischen funktionellen Schichten 41, 42 und/oder 43, 44 eine Energiebarriere für Ladungsträger in Richtung der organischen funktionellen Schichten 51, 52, 53 aufweisen.

In Figur 16 ist ein entsprechendes Energieschema für eine Energiebarriere in den löcherleitenden Schichten 41, 42 gezeigt. Hierbei sind die Energieniveaus (HOMO: "highest occupied molecular orbital", LUMO: "lowest unoccupied molecular orbital") der zwei benachbarten organischen funktionellen Schichten 41 und 42 gezeigt. Die Materialien der Schichten 41 und 42 sind lochleitend und weisen eine Beweglichkeit für Löcher auf, die größer als die entsprechende Beweglichkeit für Elektronen ist. Der Absolutwert des Energieniveaus HOMO2 der organischen funktionellen Schicht 42 ist größer als der Absolutwert des Energieniveaus HOMO1 der organischen funktionellen Schicht 41, sodass an der Grenzfläche zwischen diesen beiden Schichten beziehungsweise den beiden Energieniveaus ein energetischer Abstand $\Delta E_{HOMO}$ besteht. Bevorzugt beträgt $\Delta E_{HOMO}$ mindestens 0,1 eV. Im Betrieb des organischen Licht emittierenden Bauelements müssen Löcher beim Übergang von der organischen funktionellen Schicht 41 zur organischen funktionellen Schicht 42 die Energiebarriere $\Delta E_{HOMO}$ überwinden. Je größer die angelegte Betriebsspannung am organischen Licht emittierenden Bauelement 107 ist, umso mehr Löcher können die Energiebarriere überwinden und somit zum Löcherstrom im Bauelement 107 beitragen.

Bei einer niedrigen Betriebsspannung gelangen somit nur wenige Löcher zu den organischen Licht emittierenden Schichten 51, 52, 53, wobei ein Großteil der Löcher bereits in der organischen Licht emittierenden Schicht 51 mit Elektronen rekombiniert, sodass in den organischen Licht emittierenden Schichten 52, 53 die Anzahl der erzeugten Photonen durch entsprechende Rekombinationen von Löchern und Elektronen niedriger als die Anzahl der in der organischen Licht emittierenden Schicht 51 erzeugten Photonen ist. Dadurch ist die Emissionsintensität der organischen Licht emittierenden Schicht 51 größer als die Emissionsintensität der organischen Licht emittierenden Schicht 52, die wiederum größer als die Emissionsintensität der organischen Licht emittierenden Schicht 53 ist. Bei einer hohen Betriebsspannung hingegen gelangen mehr Löcher auch in die organischen Licht emittierenden Schichten 52 und 53, sodass in diesen relativ zur Emissionsintensität der organischen Licht emittierenden Schicht 51 eine höhere Emissionsintensität als bei einer niedrigen Betriebsspannung erreicht werden kann. Bei einer Emissionsfarbenkombination wie vorab beschrieben führt dies zu einem warmweißen Farbeindruck bei niedrigen Betriebsspannungen und einem neutralweißen Farbeindruck bei hohen Betriebsspannungen.

Zusätzlich oder alternativ können auch auf der elektronenleitenden Seite des organischen funktionellen Schichtenstapels 4 die organischen funktionellen Schichten 43 und 44 eine entsprechende Energiebarriere für Elektronen ausbilden. Figur 17 zeigt die Energieniveaus der organischen funktionellen Schichten 43 und 44. Die Materialien der Schichten 43 und 44 sind elektronenleitend und weisen eine Beweglichkeit für Elektronen auf, die größer als die entsprechende Beweglichkeit für Löcher ist. Analog zu den Energieverhältnissen auf der löcherleitenden Seite, wie sie in Verbindung mit Figur 16 beschrieben sind, besteht an der Grenzfläche zwischen den organischen funktionellen Schichten 43 und 44 zwischen den beiden Energieniveaus LUMO3 und LUMO4 ein energetischer Abstand $\Delta E_{LUMO}$, der ebenfalls bevorzugt mindestens 0,1 eV beträgt. Im Betrieb eines organischen Licht emittierenden Bauelements mit einer solchen Energiebarriere $\Delta E_{LUMO}$ müssen Elektronen beim Übergang von Schicht 44 zur Schicht 43 die Energiebarriere $\Delta E_{LUMO}$ überwinden. Je größer die an das Bauelement 107 angelegte Betriebsspannung ist, umso mehr Elektronen können die Energiebarriere überwinden und somit zum Elektronenstrom im Bauelement 107 beitragen. Entsprechend der vorherigen Beschreibung gelangen bei einer hohen Betriebsspannung ausreichend viele Elektronen in die organischen Licht emittierenden Schichten 51, 52, 53, sodass bei der entsprechenden Kombination von Emissionsfarben eine neutralweiße Farbe emittiert wird. Bei einer niedrigeren Betriebsspannung gelangen weniger Elektronen über die Grenzfläche, sodass relativ zur Emissionsstärke der organischen Licht emittierenden Schicht 53 eine reduzierte Emissionsstärke aus den organischen Licht emittierenden Schichten 51 und 52 beobachtet wird, was in einer kaltweißen Emissionsfarbe des Bauteils resultiert.

Aufgrund des in Verbindung mit den vorherigen Ausführungsbeispielen beschriebenen Spannungsabfalls, der zu einem Leuchtdichtegradienten führt, kann bei Verwendung eines in Verbindung mit den Figuren 15 bis 17 beschriebenen organischen funktionellen Schichtenstapels 4 zusätzlich ein Farbgradient erzeugt werden, der gemäß den vorab beschriebenen Verfahren wie de Leuchtdichtegradient variiert werden kann.

Bei den in Verbindung mit den Figuren beschriebenen Ausführungsbeispielen für organische Licht emittierende Bauelemente und Betriebsverfahren erlaubt die Kombination der beschriebenen Geometrien und Betriebsparameter durch einen PWM-Betrieb ein gezieltes Einstellen sowie eine gezielte Variation von Leuchtdichtegradienten oder von Leuchtdichtegradienten und Farbgradienten. Gleichzeitig kann unabhängig vom gewählten Gradienten die Helligkeit des organischen Licht emittierenden Bauelements eingestellt werden. So ist es möglich, verschiedene organische funktionelle Schichtenstapel mit verschiedenen Kennlinien hinsichtlich des gewünschten Gradienten an vorgegebene Bedingungen anzupassen. Weiterhin können die Gradienten durch eine Modulation des PWM-Signals zeitlich variiert werden, wodurch eine Belebtheit ("vividness") der Leuchtflächen erreicht werden kann.

Die Erfindung ist nicht durch die Beschreibung anhand der Ausführungsbeispiele auf diese beschränkt. Die Erfindung wird durch die Patentansprüche definiert.

**Patentansprüche**

1. Verfahren zum Betrieb eines streifenförmigen organischen Licht emittierenden Bauelements,
   wobei das organische Licht emittierende Bauelement eine erste Elektrode (2) und eine zweite Elektrode (3) aufweist, zwischen denen ein organischer funktioneller Schichtenstapel (4) mit zumindest einer organischen Licht emittierenden Schicht (5, 51, 52, 53) angeordnet ist, die im Betrieb Licht erzeugt, das über eine Leuchtfläche (10) abgestrahlt wird,
   wobei die erste und zweite Elektrode (2, 3) und der organische funktionelle Schichtenstapel (4) jeweils großflächig als zusammenhängende und nicht in funktionale Bereiche strukturierte Fläche ausgebildet sind,
   wobei in Kontakt mit der ersten Elektrode (2) an zwei sich gegenüber liegenden Rändern der ersten Elektrode (2) jeweils eine sich in einer Längsrichtung entlang des jeweiligen Randes erstreckende Leiterbahn (80, 81) angeordnet ist,
   wobei die zwei Leiterbahnen (80, 81) auf einer selben Seite der ersten Elektrode (2) mittels eines Anschlusselements (70, 71) kontaktiert werden, so dass in jeder Leiterbahn (80, 81) im Betrieb ein Spannungsabfall entlang der Längsrichtung vorliegt, der einen Leuchtdichtegradienten (99) auf der Leuchtfläche (10) in einer Richtung entlang der Längsrichtung bewirkt,
   wobei das organische Licht emittierende Bauelement eine Kennlinie r = dV/dj aufweist,
   wobei V eine Betriebsspannung und j eine Betriebsstromdichte bezeichnet und dV/dj die mathematische Ableitung der Betriebsspannung nach der Betriebsstromdichte ist,
   wobei ein Arbeitspunkt r = $r_A$ so gewählt wird, dass gilt: $0,75 \leq U \leq 1$, mit U = 1 - (1 - H)/(1 + H), H = $\cosh^{-1}$ (L/$\Lambda$) und $\Lambda$ = $(r/R)^{0,5}$,
   wobei d einen Abstand der Leiterbahnen (80, 81) zueinander in einer Richtung quer zur Längsrichtung bezeichnet, L = 0,5 $\times$ d und R der Flächenwiderstand der ersten Elektrode (2) ist.

2. Verfahren nach Anspruch 1, wobei das organische optoelektronische Bauelement beim Arbeitspunkt r = $r_A$ mit einer Betriebsstromdichte $j_A$ betrieben wird und eine Helligkeit der Leuchtfläche (10) mittels Pulsweitenmodulation der Betriebsstromdichte $j_A$ eingestellt wird.

3. Verfahren nach Anspruch 1, wobei ein erster Arbeitspunkt $r = r_{A1}$ mit einer entsprechenden Betriebsstromdichte $j_{A1}$ und ein zweiter Arbeitspunkt $r = r_{A2}$ mit einer entsprechenden Betriebsstromdichte $j_{A2}$ gewählt wird mit $j_{A2} > j_{A1}$, wobei für $r = r_{A1}$ und $r = r_{A2}$ jeweils $0,75 \leq U \leq 1$ gilt und ein Leuchtdichtegradient (99) auf der Leuchtfläche variiert wird durch eine Variation der Betriebsstromdichte j mit $j_{A1} \leq j \leq j_{A2}$.

4. Verfahren nach Anspruch 3, wobei mittels Pulsweitenmodulation ein zeitliches Mittel der Betriebsstromdichte j für $j_{A1} \leq j \leq j_{A2}$ konstant gehalten wird.

5. Verfahren nach einem der vorherigen Ansprüche, wobei $r = r_A$ so gewählt wird, dass gilt: $0,8 \leq U \leq 0,99$.

6. Verfahren nach einem der vorherigen Ansprüche, wobei sich jede der zwei Leiterbahnen (80, 81) entlang des gesamten jeweiligen Randes in Längsrichtung über einen Randbereich der ersten Elektrode (2) erstreckt und die Leiterbahnen (80, 81) einen Flächenwiderstand von größer oder gleich 10 mΩ/sq und kleiner oder gleich 1000 mQ/sq aufweisen.

7. Verfahren zum Betrieb eines streifenförmigen organischen Licht emittierenden Bauelements,
   wobei das organische Licht emittierende Bauelement eine erste Elektrode (2) und eine zweite Elektrode (3) aufweist, zwischen denen ein organischer funktioneller Schichtenstapel (4) mit zumindest einer organischen Licht emittierenden Schicht (5, 51, 52, 53) angeordnet ist, die im Betrieb Licht über eine Leuchtfläche (10) abstrahlt,
   wobei die erste und zweite Elektrode (2, 3) und der organische funktionelle Schichtenstapel (4) jeweils großflächig als zusammenhängende und nicht in funktionale Bereiche strukturierte Fläche ausgebildet sind,
   wobei die erste Elektrode (2) mittels zumindest eines ersten Anschlusselements (70) an einem Rand der ersten Elektrode (2) kontaktiert wird, so dass in der ersten Elektrode (2) entlang einer vom zumindest einen ersten Anschlusselement (70) wegführenden Richtung ein Spannungsabfall vorliegt, der einen Leuchtdichtegradienten (99) auf der Leuchtfläche (10) entlang der vom zumindest einen ersten Anschlusselement (70) wegführenden Richtung bewirkt,
   wobei das organische Licht emittierende Bauelement eine Kennlinie $r = dV/dj$ aufweist,
   wobei V eine Betriebsspannung und j eine Betriebsstromdichte bezeichnet und $dV/dj$ die mathematische Ableitung der Betriebsspannung nach der Betriebsstromdichte ist,
   wobei ein Arbeitspunkt $r = r_A$ so gewählt wird, dass gilt:
   $U \leq 0,2$, mit $U = 1 - (1 - H) / (1 + H)$, $H = \cosh^{-1}(L/\Lambda)$ und $A = (r/R)^{0,5}$,
   wobei d eine Breite der Leuchtfläche quer zum Rand der ersten Elektrode (2) mit dem zumindest einen Anschlusselement (70) bezeichnet, $L = d$ und R der Flächenwiderstand der ersten Elektrode (2) ist.

8. Verfahren nach Anspruch 7, wobei das organische optoelektronische Bauelement beim Arbeitspunkt $r = r_A$ mit einer Betriebsstromdichte $j_A$ betrieben wird und eine Helligkeit der Leuchtfläche (10) mittels Pulsweitenmodulation der Betriebsstromdichte $j_A$ eingestellt wird.

9. Verfahren nach Anspruch 7, wobei ein erster Arbeitspunkt $r = r_{A1}$ mit einer entsprechenden Betriebsstromdichte $j_{A1}$ gewählt wird, für den $U \geq 0,8$ gilt, und ein zweiter Arbeitspunkt $r = r_{A2}$ mit einer entsprechenden Betriebsstromdichte $j_{A2}$ gewählt wird, für den $U \leq 0,2$ gilt, und durch eine Variation des zwischen den Anschlusselementen und der zweiten Elektrode anliegender Betriebsstroms j mit $j_{A1} \leq j \leq j_{A2}$ eine Variation zwischen einem Leuchtdichtegradienten (99) auf der Leuchtfläche (10) beim zweiten Arbeitspunkt $r_{A2}$ und keinem Leuchtdichtegradienten (99) auf der Leuchtfläche beim ersten Arbeitspunkt $r_{A1}$ erzeugt wird.

10. Verfahren nach Anspruch 9, wobei mittels Pulsweitenmodulation ein zeitliches Mittel der Betriebsstromdichte für jede Betriebsstromdichte j mit $j_{A1} \leq j \leq j_{A2}$ konstant gehalten wird.

11. Verfahren nach einem der Ansprüche 7 bis 9, wobei eine Mehrzahl von Anschlusselementen (70, 71, 72, 73, 74) nebeneinander entlang desselben Rands der ersten Elektrode (2) angeordnet ist.

12. Verfahren nach einem der Ansprüche 7 bis 10, wobei zumindest ein weiteres Anschlusselement oder eine Mehrzahl von weiteren Anschlusselementen (73, 74, 75, 76, 77, 78, 79) an einem Rand der ersten Elektrode (2) angeordnet ist, der dem Rand mit dem zumindest einen ersten Anschlusselement (70) gegenüber liegt.

**13.** Verfahren nach einem der Ansprüche 7 bis 11, wobei an einer Mehrzahl von Rändern der ersten Elektrode (2) jeweils eine Mehrzahl von Anschlusselementen (70, 71, 72, 73, 74, 75, 76, 77, 78, 79) angeordnet ist.

**14.** Verfahren nach einem der vorherigen Ansprüche, wobei die Leuchtfläche (10) eine rechteckige Form oder eine von einem Rechteck abgeleitete Freiform aufweist.

**15.** Verfahren nach einem der vorherigen Ansprüche,
wobei der organische funktionelle Schichtenstapel (4) zumindest zwei organische Licht emittierende Schichten (51, 52, 53) aufweist, die im Betrieb Licht mit unterschiedlichen Wellenlängen abstrahlen, und
wobei zumindest zwei organische funktionelle Schichten (41, 42, 43, 44) zwischen einer Elektrode (2, 3) und den organischen Licht emittierenden Schichten (51, 52, 53) eine Energiebarriere für Ladungsträger in Richtung der organischen funktionellen Schichten (51, 52, 53) aufweisen.

**Claims**

**1.** A method for operating a strip-shaped organic light-emitting component,
wherein the organic light-emitting component has a first electrode (2) and a second electrode (3) that have arranged between them an organic functional layer stack (4) having at least one organic light-emitting layer (5, 51, 52, 53) that, during operation, produces light that is emitted via a luminous area (10),
wherein the first and second electrodes (2, 3) and the organic functional layer stack (4) each embodied in an extensive form as a contiguous area that is not structured into functional regions, respectively, wherein, in contact with the first electrode (2), at each of two opposite edges of the first electrode (2) a respective conductor track (80, 81) is arranged that extends in a longitudinal direction along the respective edge,
wherein the two conductor tracks (80, 81) have contact made with them on a same side of the first electrode (2) by means of a connection element (70, 71), so that during operation there is a voltage drop in each conductor track (80, 81) in the longitudinal direction, which voltage drop brings about a luminous density gradient (99) on the luminous area (10) in a direction following the longitudinal direction,
wherein the organic light-emitting component has a characteristic $r = dV/dj$,
where V denotes an operating voltage and j denotes an operating current density and $dV/dj$ is the mathematical derivative of the operating voltage with respect to the operating current density,
wherein an operating point $r = r_A$ is chosen such that it holds that: $0.75 \leq U \leq 1$, with

$$U = 1 - (1 - H)/(1 + H), \quad H = \cosh^{-1}(L/\Lambda)$$

and

$$\Lambda = (r/R)^{0.5},$$

where d denotes a distance between the conductor tracks (80, 81) in a direction transverse to the longitudinal direction, $L = 0.5 \times d$ and R is the sheet resistance of the first electrode (2).

**2.** The method according to claim 1, wherein the organic optoelectronic component is operated with an operating current density $j_A$ at the operating point $r = r_A$, and a luminosity of the luminous area (10) is set by means of pulse width modulation of the operating current density $j_A$.

**3.** The method according to claim 1, wherein a first operating point $r = r_{A1}$ having a corresponding operating current density $j_{A1}$ and a second operating point $r = r_{A2}$ having a corresponding operating current density $j_{A2}$ are chosen, with $j_{A2} > J_{A1}$, wherein $0.75 \leq U \leq 1$ holds for each $r = r_{A1}$ and $r_{A2}$ and a luminous density gradient (99) on the luminous area is varied by varying the operating current density j with $j_{A1} \leq j \leq j_{A2}$.

**4.** The method according to claim 3, wherein pulse width modulation is used to keep an average of the operating current density j over time at a constant value for $j_{A1} \leq j \leq j_{A2}$.

**5.** The method according to one of the preceding claims, wherein $r = r_A$ is chosen such that it holds that: $0.8 \leq U \leq 0.99$.

6. The method according to one of the preceding claims, wherein each of the two conductor tracks (80, 81) extends along the entire respective edge in the longitudinal direction over an edge region of the first electrode (2), and the conductor tracks (80, 81) have a sheet resistance of greater than or equal to 10 mΩ/sq and less than or equal to 1000 mΩ/sq.

7. A method for operating a strip-shaped organic light-emitting component,
wherein the organic light-emitting component has a first electrode (2) and a second electrode (3) that have arranged between them an organic functional layer stack (4) having at least one organic light-emitting layer (5, 51, 52, 53) that, during operation, emits light via a luminous area (10),
wherein the first and second electrodes (2, 3) and the organic functional layer stack (4) each are embodied in an extensive form as a contiguous area that is not structured into functional regions, respectively, wherein the first electrode (2) has contact made with it by means of at least one first connection element (70) at an edge of the first electrode (2), so that there is a voltage drop in the first electrode (2) in a direction that leads away from the at least one first connection element (70), which voltage drop brings about a luminous density gradient (99) on the luminous area (10) in the direction that leads away from the at least one first connection element (70),
wherein the organic light-emitting component has a characteristic $r = dV/dj$,
where V denotes an operating voltage and j denotes an operating current density, and $dV/dj$ is the mathematical derivative of the operating voltage with respect to the operating current density,
wherein an operating point $r = r_A$ is chosen such that it holds that:
$U \leq 0.2$, with $U = 1 - (1 - H) / (1 + H)$, $H = \cosh^{-1} (L/\Lambda)$ and $\Lambda = (r/R)^{0.5}$,
where d denotes a width of the luminous area transversely to the edge of the first electrode (2) having the at least one connection element (70), $L = d$ and R is the sheet resistance of the first electrode (2).

8. The method according to claim 7, wherein the organic optoelectronic component is operated with an operating current density $j_A$ at the operating point $r = r_A$, and a luminosity of the luminous area (10) is set by means of pulse width modulation of the operating current density $j_A$.

9. The method according to claim 7, wherein a first operating point $r = r_{A1}$ having a corresponding operating current density $j_{A1}$ is chosen, for which it holds that $U \geq 0.8$, and a second operating point $r = r_{A2}$ having a corresponding operating current density $j_{A2}$ is chosen, for which it holds that $U \leq 0.2$, and a variation in the operating current j that is present between the connection elements and the second electrode with $j_{A1} \leq j \leq j_{A2}$ produces a variation between a luminous density gradient (99) on the luminous area (10) at the second operating point $r_{A2}$ and no luminous density gradient (99) on the luminous area at the first operating point $r_{A1}$.

10. The method according to claim 9, wherein pulse width modulation is used to keep an average of the operating current density over time at a constant value for each operating current density j with
$j_{A1} \leq j \leq j_{A2}$.

11. The method according to one of claims 7 to 9, wherein a plurality of connection elements (70, 71, 72, 73, 74) are arranged next to one another along the same edge of the first electrode (2).

12. The method according to one of claims 7 to 10, wherein at least one further connection element or a plurality of further connection elements (73, 74, 75, 76, 77, 78, 79) is/are arranged at an edge of the first electrode (2) that is opposite the edge having the at least one first connection element (70).

13. The method according to one of claims 7 to 11, wherein a plurality of connection elements (70, 71, 72, 73, 74, 75, 76, 77, 78, 79) are arranged at each of a plurality of edges of the first electrode (2).

14. The method according to one of the preceding claims, wherein the luminous area (10) has a rectangular form or a free form that is derived from a rectangle.

15. The method according to one of the preceding claims, wherein the organic functional layer stack (4) has at least two organic light-emitting layers (51, 52, 53) that, during operation, emit light having different wavelengths, and wherein at least two organic functional layers (41, 42, 43, 44) between an electrode (2, 3) and the organic light-emitting layers (51, 52, 53) have an energy barrier for charge carriers in the direction of the organic functional layers (51, 52, 53).

**EP 3 022 782 B1**

**Revendications**

1. Procédé destiné au fonctionnement d'un composant émettant de la lumière organique par bandes,
sachant que le composant émettant de la lumière organique présente une première électrode (2) et une seconde électrode (3) entre lesquelles est disposée une pile de couches fonctionnelles organiques (4) avec au moins une couche (5, 51, 52, 53) émettant de la lumière organique, qui pendant le fonctionnement, produit de la lumière qui est dégagée via une surface lumineuse (10),
sachant que la première et la seconde électrode (2, 3) et la pile de couches fonctionnelles organiques (4) sont constituées respectivement en grandes surfaces comme surface en continu et non structurée en zones fonctionnelles,
sachant qu'en contact avec la première électrode (2) sur deux bords de la première électrode (2) se trouvant face à face est disposée respectivement une piste conductrice (80, 81) s'étendant dans une direction longitudinale le long du bord respectif,
sachant que les deux pistes conductrices (80, 81) sont mises en contact sur un même côté de la première électrode (2) au moyen d'un élément de connexion (70, 71), de sorte que dans chaque piste conductrice (80, 81), il y a présence pendant le fonctionnement d'une chute de tension le long de la direction longitudinale, qui induit un gradient de luminance (99) sur la surface lumineuse (10) dans une direction le long de la direction longitudinale,
sachant que le composant émettant de la lumière organique présente une courbe caractéristique r = dV/dj,
sachant que V désigne une tension de service et que j désigne une densité de courant de service et que dV/dj est la déduction mathématique de la tension de service selon la densité de courant de service,
sachant qu'un point de fonctionnement dynamique r = $r_A$ est sélectionné de manière à ce que s'applique :
$0{,}75 \leq U \leq 1$, avec $U = 1 - (1 - H)/(1 + H)$, $H = \cosh^{-1}(L/A)$ et $\Lambda = (r/R)^{0{,}5}$,
sachant que d désigne un écart des pistes conductrices (80, 81) les unes par rapport aux autres dans une direction transversalement à la direction longitudinale, $L = 0{,}5 \times d$ et que R est la résistance surfacique de la première électrode (2).

2. Procédé selon la revendication 1, sachant que le composant optoélectronique organique est exploité au point de fonctionnement dynamique r = $r_A$ avec une densité de courant de service $j_A$ et qu'une luminosité de la surface lumineuse (10) est réglée au moyen d'une modulation d'impulsions en largeur de la densité de courant de service $j_A$.

3. Procédé selon la revendication 1, sachant qu'un premier point de fonctionnement dynamique r = $r_{A1}$ est sélectionné avec une densité de courant de service $j_{A1}$ correspondante et un second point de fonctionnement dynamique r = $r_{A2}$ avec une densité de courant de service $j_{A2}$ correspondante avec $j_{A2} > j_{A1}$, sachant que pour r = $r_{A1}$ et r = $r_{A2}$ s'appliquent respectivement $0{,}75 \leq U \leq 1$ et qu'un gradient de luminance (99) est varié sur la surface lumineuse par une variation de la densité de courant de service j avec $j_{A1} \leq j \leq j_{A2}$.

4. Procédé selon la revendication 3, sachant qu'au moyen d'une modulation d'impulsions en largeur, un moyen temporel de la densité de courant de service j est maintenu constant pour $j_{A1} \leq j \leq j_{A2}$.

5. Procédé selon une quelconque des revendications précédentes, sachant que r = $r_{A1}$ est sélectionné de sorte que s'applique : $0{,}8 \leq U \leq 0{,}99$.

6. Procédé selon une quelconque des revendications précédentes, sachant que chacune des deux pistes conductrices (80, 81) s'étend le long du bord respectif total dans la direction longitudinale sur une zone du bord de la première électrode (2) et que les pistes conductrices (80, 81) présentent une résistance surfacique supérieure ou égale à 10 mΩ/sq et inférieure ou égale à 1000 mΩ/sq.

7. Procédé destiné au fonctionnement d'un composant émettant de la lumière organique par bandes,
sachant que le composant émettant de la lumière organique présente une première électrode (2) et une seconde électrode (3) entre lesquelles une pile de couches fonctionnelles organiques (4) est disposée avec au moins une couche émettant de la lumière organique (5, 51, 52, 53), qui, pendant le fonctionnement, dégage de la lumière via une surface lumineuse (10),
sachant que la première et la seconde électrode (2, 3) et la pile de couches fonctionnelles organiques (4) sont constituées respectivement en grandes surfaces comme surface en continu et non structurée en zones fonctionnelles,
sachant que la première électrode (2) est mise en contact au moyen d'au moins un premier élément de connexion (70) sur un bord de la première électrode (2) de sorte que dans la première électrode (2) il y a présence d'une chute de tension le long d'une direction partant d'au moins l'un des premiers éléments de connexion (70), qui induit un

17

gradient de luminance (99) sur la surface lumineuse (10) le long de la direction partant d'au moins l'un des premiers éléments de connexion (70), sac

hant que le composant émettant de la lumière organique présente une courbe caractéristique r = dV/dj, sachant que V désigne une tension de service et que j désigne une densité de courant de service et que dV/dj est la déduction mathématique de la tension de service selon la densité de courant de service,

sachant qu'un point de fonctionnement dynamique $r = r_A$ est sélectionné de manière à ce que s'applique : $U \leq 0,2$, avec U = 1 - (1 - H)/(1 + H), H = $\cosh^{-1}$ (L/Λ) et Λ = $(r/R)^{0,5}$,

sachant que d désigne une largeur de la surface lumineuse transversalement au bord de la première électrode (2) avec au moins l'un des éléments de connexion (70), que L = d et R est la résistance surfacique de la première électrode (2).

8. Procédé selon la revendication 7, sachant que le composant optoélectronique organique est exploité au point de fonctionnement dynamique $r = r_A$ avec une densité de courant de service $j_A$ et qu'une luminosité de la surface lumineuse (10) est réglée au moyen d'une modulation d'impulsions en largeur de la densité de courant de service $j_A$.

9. Procédé selon la revendication 7, sachant qu'un premier point de fonctionnement dynamique $r = r_{A1}$ est sélectionné avec une densité de courant de service $j_{A1}$ correspondante, pour lequel s'applique $U \geq 0,8$, et qu'un second point de fonctionnement dynamique $r = r_{A2}$ est sélectionné avec une densité de courant de service $j_{A2}$ correspondante, pour lequel s'applique $U \leq 0,2$, et par une variation du courant de service j appliqué avec $j_{A1} \leq j \leq j_{A2}$ entre les éléments de raccordement et la seconde électrode, qu'une variation est générée entre un gradient de luminance (99) sur la surface lumineuse (10) pour le second point de fonctionnement dynamique $r_{A2}$ et aucun gradient de luminance (99) sur la surface lumineuse pour le premier point de fonctionnement dynamique $r_{A1}$.

10. Procédé selon la revendication 9, sachant qu'au moyen d'une modulation d'impulsions en largeur, un moyen temporel de la densité de courant de service est maintenu constant pour chaque densité de courant de service j avec $J_{A1} \leq j \leq j_{A2}$.

11. Procédé selon une quelconque des revendications 7 à 9, sachant qu'une pluralité d'éléments de connexion (70, 71, 72, 73, 74) est disposée l'un à côté de l'autre, le long du même bord de la première électrode (2).

12. Procédé selon une quelconque des revendications 7 à 10, sachant qu'au moins un autre élément de connexion ou une pluralité d'autres éléments de connexion (73, 74, 75, 76, 77, 78, 79) est disposé sur un bord de la première électrode (2), qui se trouve face au bord avec au moins l'un des premiers éléments de connexion (70).

13. Procédé selon une quelconque des revendications 7 à 11, sachant que sur une pluralité de bords de la première électrode (2) est disposée respectivement une pluralité d'éléments de connexion (70, 71, 72, 73, 74, 75, 76, 77, 78, 79).

14. Procédé selon une quelconque des revendications précédentes, sachant que la surface lumineuse (10) présente une surface rectangulaire ou une forme libre déduite d'un rectangle.

15. Procédé selon une quelconque des revendications précédentes, sachant que la pile de couches fonctionnelles organiques (4) présente au moins deux couches émettant de la lumière organique (51, 52, 53), qui dégagent pendant le fonctionnement de la lumière avec différentes longueurs d'ondes et sachant qu'au moins deux couches fonctionnelles organiques (41, 42, 43, 44) présentent, entre une électrode (2, 3) et les couches émettrices de lumière organique (51, 52, 53), une barrière d'énergie pour les porteurs de charge dans la direction des couches fonctionnelles organiques (51, 52, 53).

FIG. 1

FIG. 2

FIG. 3

FIG. 4

FIG. 5

FIG. 6

FIG. 7

104

70

10

99

3
1
d
2

9

FIG. 8

105

70

9

d

10

9

FIG. 9

FIG. 10

FIG. 11

FIG. 12

FIG. 13

FIG. 14

## FIG. 15

## FIG. 16

## FIG. 17

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013107529
- US 2009189532 A1
- WO 2010066245 A1
- WO 2012052886 A2
- US 20110121354 A1
- US 20110114992 A1
- US 20110049730 A1